# EUROPÄISCHE PATENTANMELDUNG

(11) **EP 4 682 553 A1**
(43) Veröffentlichungstag der Anmeldung: **21.01.2026**
(21) Anmeldenummer: 24189749.5
(22) Anmeldetag: 19.07.2024
(51) Int. Cl.: G01R 31/12, G01R 31/34

(54) **VERFAHREN ZUR ZUSTANDSANALYSE EINES ELEKTROMECHANISCHEN ENERGIEWANDLERS, UND SYSTEM**

(71) Anmelder: Hochschule für Technik und Wirtschaft Berlin, 10318 Berlin (DE)
(72) Erfinder: GRÄF, Thomas, 12621 Berlin (DE)
(74) Vertreter: Bittner, Thomas L.

(57) **Zusammenfassung**

Die Erfindung betrifft ein Verfahren zur Zustandsanalyse eines elektromechanischen Energiewandlers (10), umfassend die Schritte: Erfassen mindestens eines Messwerts (21) des elektromechanischen Energiewandlers (10) mit mindestens einem Sensor (20), wobei mindestens einer, mehrere oder alle der Sensoren (20) in oder an dem elektromechanischen Energiewandler (10) angeordnet ist und wobei mindestens einer, mehrere oder alle der Sensoren (20) ein faseroptischer und/oder faserakustischer Sensor ist oder aufweist, wobei beim Erfassen des Messwerts (21) eines oder mehrere aus Vibration, Schall, Lichtimpulsen, Temperatur, Drehzahl, translatorische oder rotatorische Bewegung, elektrischer Spannung und/oder Stromstärke erfasst wird; Umwandeln des oder der Messwerte (21) mit mindestens einem A/D-Wandler (40) in ein jeweiliges digitales Signal (41); Durchführung einer Merkmalsextraktion des oder der digitalen Signale (41), wobei mindestens ein Merkmal (71) aus mindestens einem, mehreren oder allen digitalen Signalen (41) extrahiert wird; Durchführen einer Klassifikation des oder der extrahierten Merkmale (71) mit einem Klassifikator (80) und Bestimmen eines Zustands und/oder einer Fehlerursache des elektromechanischen Energiewandlers (10) entsprechend der Klassifikation. Die Erfindung betrifft zudem ein entsprechendes System (100).

## Beschreibung

Die Erfindung betrifft ein Verfahren zur Zustandsanalyse eines elektromechanischen Energiewandlers. Die Erfindung betrifft zudem ein entsprechendes System. Ein elektromechanischer Energiewandler kann ein Motor oder ein Generator sein, oder einen sonstigen elektromagnetischen Energiewandler aufweisen.

### Hintergrund

Die zunehmende Elektrifizierung der Gesellschaft führt zu gravierenden Änderungen im Bereich der Mobilität sowie Automatisierung. Dabei wird vor allem im Bereich der Mobilität das Verdrängen der Verbrennungsmotoren zugunsten elektrischer Antriebe vorangetrieben, insbesondere im Bereich der Verkehrswende. Die dabei eingesetzten elektrischen Motoren zeichnen sich grundlegend durch eine hohe Leistungsdichte aus, wenngleich zwischen den unterschiedlichen Motorentypen Unterschiede in der Leistungsdichte bestehen. Bei allen elektrischen Motoren sind jedoch gewickelte Spulen oder Spulenstäbe im Einsatz, die mit einer Isolierung versehen sein müssen. Das dabei notwendige Isoliervermögen ist von verschiedenen Parametern abhängig, so z.B. von der Lackschichtdicke, dem verwendeten Isolierlack, der Spannungshöhe, der Spannungssteilheit, der Frequenz, den Umgebungsbedingungen. Grundlegend ist jedoch, dass das Versagen von Isolationen in Motoren zu dessen Ausfall führt, so dass die im Vorfeld auftretenden Teilentladungen als Indikator für ein Versagen der Isolation hohe Bedeutung haben.

Eine Teilentladung kann insbesondere eine kurzzeitige, energiearme und lokal begrenzte Entladung in einer Isolierung, z.B. einer Isolierung einer Wicklung eines Motors oder eines Generators, sein. Eine Teilentladung muss nicht zwingend sofort zu einem elektrischen Durchschlag führen, beschädigt jedoch das Material der Isolierung.

Teilentladungsmessungen an Motoren und deren Wicklung werden z.B. fertigungsbegleitend im Rahmen der Qualitätssicherung durchgeführt. Ebenso kann im Zuge einer Wartung eine Messung hinsichtlich des Auftretens von Teilentladungen an Motoren erfolgen. Dabei erfolgt die Einspeisung von impulsförmigen Prüfspannungen unterschiedlicher Kurvenform. Mittels diskreter Sensoren unterschiedlicher Bauart und unterschiedlicher physikalischer Erfassung, hier werden in der Regel akustische Sensoren, (Piezo- oder Ultraschallsensoren), Antennen (elektromagnetische Erfassung) oder elektrisch gekoppelte Sensoren eingesetzt, die entweder kapazitiv, induktiv oder resistiv ankoppeln.

Problematisch bei Motoren ist allerdings die Tatsache, dass lediglich an den Wicklungsenden der Zugang zu den elektrischen Anschlüssen möglich ist. Somit können Teilentladungen, die entlang einer Wicklung oder an den Wicklungsköpfen auftreten, nur durch Laufzeiteffekte von Teilentladungsimpulsen, oder durch Triangulation erfasst werden. Auch eine Erfassung bei geöffnetem Motor ist möglich, wenngleich dann allerdings der Motor nur mit seinen Komponenten zur Verfügung steht und nicht im Betrieb sein kann. Teilentladungen führen bei Motoren unweigerlich früher oder später zum Ausfall des Motors. Daher ist die frühzeitige Erkennung von Teilentladungen eine Maßnahme, Totalausfälle sowie kostspielige Folgen zu vermeiden.

Ein faseroptischer Sensor zur Bestimmung eines Messwerts in einem Stromkabel und ein entsprechendes Verfahren ist aus der DE 10 2016 108 122 B3 bekannt. Ein Messvorrichtung zum Bestimmen einer physikalischen Messgröße mit einem faseroptischen Sensor ist beispielsweise aus der DE 10 2018 104 953 A1 bekannt.

### Zusammenfassung

Es ist deshalb Aufgabe der Erfindung, ein Verfahren und ein System bereitzustellen, das genau, zuverlässig und kostengünstig einen elektromechanischen Energiewandler überwachen und dessen Zustand bestimmen kann.

Diese Aufgabe wird durch ein Verfahren nach Anspruch 1, sowie durch ein System nach Anspruch 11, gelöst. Die abhängigen Ansprüche betreffen jeweils vorteilhafte Ausführungsformen.

Ein erster Aspekt der Erfindung betrifft ein Verfahren zur Zustandsanalyse eines elektromechanischen Energiewandlers, umfassend die Schritte:
- Erfassen mindestens eines Messwerts des elektromechanischen Energiewandlers mit mindestens einem Sensor, wobei mindestens einer, mehrere oder alle der Sensoren in oder an dem elektromechanischen Energiewandler angeordnet ist und wobei mindestens einer, mehrere oder alle der Sensoren ein faseroptischer und/oder faserakustischer Sensor ist oder aufweist, wobei beim Erfassen des Messwerts eines oder mehrere aus Vibration, Schall, Lichtimpulsen, Temperatur, Drehzahl, translatorische oder rotatorische Bewegung, elektrischer Spannung und/oder Stromstärke erfasst wird;
- Umwandeln des oder der Messwerte mit mindestens einem A/D-Wandler in ein jeweiliges digitales Signal;
- Durchführung einer Merkmalsextraktion des oder der digitalen Signale, wobei mindestens ein Merkmal aus mindestens einem, mehreren oder allen digitalen Signalen extrahiert wird;
- Durchführen einer Klassifikation des oder der extrahierten Merkmale mit einem Klassifikator und Bestimmen eines Zustands und/oder einer Fehlerursache des elektromechanischen Energiewandlers entsprechend der Klassifikation, wobei bevorzugt eine in dem elektromechanischen Energiewandler auftretende Teilentladung erkannt und/oder bestimmt wird, wobei bevorzugt beim Klassifizieren das oder die extrahierten Merkmale gruppiert werden.

Mindestens ein Schritt des Verfahrens kann computer-implementiert sein.

Das Verfahren ermöglicht, den elektrisch aktiven Teil des elektromechanischen Energiewandlers automatisch zu überwachen und den Zustand zu bestimmen oder eine Fehlerursache zu ermitteln. Bei spontan auftretenden Problemen kann verhindert werden, dass der elektromechanische Energiewandler außer Betrieb genommen werden muss, oder zumindest länger außer Betrieb genommen werden muss, z.B. weil ein Auftreten von Teilentladungen zur Zerstörung des elektromechanischen Energiewandlers führt.

Die Erfindung hat den Vorteil, dass durch ein einfaches Anbringen der Sensoren in den elektromechanischen Energiewandler bereits eine Zustandsanalyse und/oder ein permanentes Monitoring möglich sind. Im Gegensatz zu bisherigen Analysen an elektromechanischen Energiewandlern ist damit ein Eingriff in oder eine Demontage des elektromechanischen Energiewandlers zur Bestimmung dessen Zustands und/oder einer Fehlerursache nicht erforderlich. Auch muss der elektromechanische Energiewandler nicht außer Betrieb gesetzt werden und es ist kein Eingriff in die Ansteuerung des elektromechanischen Energiewandlers notwendig. Somit entfallen lange Ausfallzeiten des elektromechanischen Energiewandlers, in denen dieser nicht zur Verfügung steht.

Mit dem Verfahren kann ein entsprechend ausgestatteter elektromechanischer Energiewandler beispielsweise permanent überwacht werden. Eine Überwachung, z.B. eine Onlineüberwachung, des Zustands des elektromechanischen Energiewandlers kann beispielsweise im laufenden Betrieb ermöglicht sein, und/oder erfolgen. Damit können routinemäßige Überprüfungen entweder entfallen, oder zumindest kann ein Wartungsintervall im Vergleich zu herkömmlichen Verfahren verlängert werden, wodurch Kosten eingespart werden können.

Ein Zustand kann beispielsweise eine Strukturintegrität und/oder eine mechanische Stabilität des elektromechanischen Energiewandlers und/oder dessen Komponenten umfassen, und/oder beim Bestimmen des Zustands kann eine Strukturintegrität und/oder eine mechanische Stabilität des elektromechanischen Energiewandlers bestimmt sein oder werden. Ein Zustand kann beispielsweise eine Vibration, ein Geräusch, ein Schall, eine Teilentladung und/oder eine Temperatur des elektromechanischen Energiewandlers umfassen, und/oder beim Bestimmen des Zustands kann eine Vibration, ein Geräusch, ein Schall, eine Teilentladung und/oder eine Temperatur des elektromechanischen Energiewandlers bestimmt sein oder werden. Ein Zustand kann beispielsweise ein Vibrationsspektrum des elektromechanischen Energiewandlers umfassen, und/oder beim Bestimmen des Zustands kann ein Vibrationsspektrum des elektromechanischen Energiewandlers bestimmt sein oder werden. Ein Zustand kann beispielsweise eine elektrische Spannung und/oder eine Stromstärke, z.B. eines eine Wicklung des elektromechanischen Energiewandlers durchfließenden Stroms, umfassen, und/oder beim Bestimmen des Zustands kann elektrische Spannung und/oder eine Stromstärke des elektromechanischen Energiewandlers bestimmt sein oder werden. Ein Zustand kann beispielsweise eine Erwärmung und/oder Abkühlung des elektromechanischen Energiewandlers umfassen, und/oder beim Bestimmen des Zustands kann eine Erwärmung und/oder Abkühlung des elektromechanischen Wandlers bestimmt sein oder werden. Ein Zustand kann beispielsweise ein Betriebszustand des elektromechanischen Energiewandlers sein oder umfassen, und/oder beim Bestimmen des Zustands kann ein Betriebszustand des elektromechanischen Wandlers bestimmt sein oder werden. Ein Zustand kann beispielsweise eine Güte, Strukturintegrität und/oder ein Zustand einer Isolation des elektromechanischen Energiewandlers sein oder umfassen, und/oder beim Bestimmen des Zustands kann eine Güte, Strukturintegrität und/oder ein Zustand einer Isolation des elektromechanischen Wandlers bestimmt sein oder werden. Ein Zustand kann beispielsweise die Erfassung der Drehzahl des elektromagnetischen Energiewandlers sein oder umfassen. Ein Zustand kann beispielsweise die Erfassung einer translatorischen oder rotatorischen Bewegung eines elektromagnetischen Energiewandlers sein oder umfassen.

Bei der Zustandsanalyse und/oder Bestimmung des Zustands und/oder der Fehlerursache kann beispielsweise ein Verschleiß des elektromechanischen Energiewandlers und/oder einer dessen Komponenten bestimmt sein oder werden. Beispielsweise kann ein Zustand umfassen, dass der elektromechanische Energiewandler aktuell keiner Wartung bedarf. Beispielsweise kann ein Zustand umfassen, dass der elektromechanische Energiewandler weiter betrieben werden kann, aber zeitnah gewartet werden sollte. Beispielsweise kann ein Zustand umfassen, dass der elektromechanische Energiewandler nicht mehr sicher betrieben werden kann. Diese Zustände sind natürlich nur beispielhaft, und es können weitere und/oder andere Zustände vorliegen, und/oder ermittelt oder bestimmt sein oder werden.

Eine Fehlerursache kann beispielsweise eine Teilentladung umfassen. Eine Fehlerursache kann beispielsweise ein Zustand und/oder ein zeitlicher Verlauf eines Zustands einer Isolierung umfassen. Eine Fehlerursache kann beispielsweise ein Schaden einer Lagerung des elektromechanischen Energiewandlers, z.B. einer Welle eines Läufers, umfassen. Diese Fehlerursachen sind natürlich nur beispielhaft, und es können weitere und/oder andere Fehlerursachen vorliegen, und/oder ermittelt oder bestimmt sein oder werden.

Das nachfolgend beschriebene Verfahren führt zur Erkennung von Teilentladungen während dem Betrieb eines Motors und kann somit bereits in der Frühphase des Auftretens von Teilentladungen einen Totalausfall sowie hohe Folgekosten verhindern. Das nachfolgend beschriebene Verfahren beruht auf dem Einsatz von faseroptischen bzw. faser-akustischen Sensoren innerhalb eines Motors.

Zur Durchführung der Bestimmung des Zustands, insbesondere bezüglich eines Ermittelns oder Feststellens eines Auftretens von z.B. Teilentladungen, oder beispielsweise Änderungen des Vibrationsspektrums des elektromechanischen Energiewandlers, kann ein Ausbau und außer Betrieb nehmen nicht erforderlich sein, anders als bei herkömmlichen oder üblichen Wartungen, bei denen ein Ausbau oder zumindest ein außer Betrieb nehmen und/oder einen Eingriff in die Steuerung des elektromechanischen Energiewandlers notwendig sein kann.

Bei dem Verfahren kann ein einfaches und kostengünstiges eingebettetes System sowie geeignete kostengünstiger, faseroptischer und/oder faserakustische Sensoren vorgesehen sein. Die Fertigung eines entsprechend ausgestatteten elektromechanischen Energiewandlers ist daher kaum teurer als die eines herkömmlichen elektromechanischen Energiewandlers. Gleichzeitig kann jedoch ein erheblicher Mehrwert erzielt werden, da z.B. eine Fernwartung und Monitoring möglich sind. In einigen Ausführungsformen kann der Zustand des elektromechanischen Energiewandlers permanent beobachtet werden, wodurch sich ein erhebliches Einsparpotenzial bzgl. Wartungs- und Instandhaltungskosten ergeben kann.

Dadurch, dass die Sensoren faseroptische und/oder faserakustischen Sensoren sind, können diese in einer Weise in oder an dem elektromechanischen Energiewandler angeordnet und/oder montiert sein oder werden, ohne dass sicherheitskritische Komponenten verändert werden müssen. Auch ist ein Kontakt z.B. zu Nieder- oder Hochspannung führenden Bauteilen weder erforderlich, noch schädlich. Beim Einsatz faseroptischer Sensoren und/oder faserakustischer Sensoren ist ein Kontakt der Sensoren z.B. mit Nieder- und Hochspannung führenden Bauteilen möglich.

Ein oder der Sensor, insbesondere ein oder der faseroptische und/oder faserakustische Sensor, kann eine Faser aufweisen. Der Sensor kann eine Glasfaser und/oder eine Kunststofffaser aufweisen. Die Faser kann eine Glasfaser oder Kunststofffaser sein. Der Sensor und/oder die Faser kann einen Lichtwellenleiter umfassen. Die Faser kann dazu eingerichtet sein, ihre Lichtleitungseigenschaft, z.B. eine Beugung, ein Reflexionsvermögen, eine Streuung, eine Interferenz, eine Transmission, eine Wellenlänge, eine Dehnung, eine Rückstreuung oder dergleichen, zu verändern, wenn sie eine Vibration und/oder Schall, und/oder Temperatur, erfasst. Beispielsweise kann sich die Lichtwelleneigenschaft durch eine (ggf. lokale) Dehnung, Längenänderung und/oder Verformung der Faser, z.B. der Glasfaser, infolge von Vibrationen und/oder Schall, und/oder Temperaturänderungen, ergeben. Die veränderte Lichtleitungseigenschaft kann erfasst werden, beispielsweise von einer Erfassungseinheit und/oder mit einem Interferometer. Die erfasste veränderte Lichtleitungseigenschaft kann ein Maß für die Vibration und/oder den Schall, und/oder Temperatur sein, und/oder diese charakterisieren oder bestimmbar machen.

In einigen Ausführungsformen kann der Sensor, und/oder die Faser, einen Lichtimpuls, beispielsweise ein oder mehrere Photonen, erfassen, die z.B. bei einer Teilentladung auftreten und/oder entstehen können. Der Lichtimpuls kann von dem Sensor und/oder der Faser geleitet werden. Der Lichtimpuls kann von einer Erfassungseinheit, z.B. einem Interferometer, erfasst sein oder werden. Der erfasste Lichtimpuls kann ein Maß für eine Teilentladung sein, und/oder diese charakterisieren oder bestimmbar machen. Bei einer Teilentladung kann ein Lichtimpuls auftreten und/oder erzeugt sein oder werden, beispielsweise an oder in einer Isolierung.

Die Erfassungseinheit kann ein Interferometer sein oder aufweisen. Das Interferometer kann beispielsweise ein Michelson-Interferometer sein oder aufweisen. Das Interferometer kann beispielsweise ein Sagnac-Interferometer sein oder aufweisen. Das Interferometer kann beispielsweise ein Mach-Zehnder-Interferometer sein oder aufweisen.

In einigen Ausführungsformen kann ein oder der Sensor, insbesondere ein oder der faseroptische Sensor und/oder faserakustische Sensor, ein Bragg-Gitter, z.B. ein Faser-Bragg-Gitter, zur Messung und/oder Erfassung des Messwerts aufweisen.

In einigen Ausführungsformen kann ein oder der Sensor, insbesondere ein oder der faseroptische Sensor und/oder faserakustische Sensor alternativ oder zusätzlich dazu eingerichtet sein, eine Temperatur, Dehnung, Spannung, Strom, und/oder mechanische Beanspruchung zu erfassen.

Eine oder die Spannung kann z.B. in einigen Ausführungsformen durch eine Veränderung der Kristallstruktur der Faser und/oder des faseroptischen Sensors und daraus resultierenden Reflexionen ermittelt sein oder werden. Alternativ oder zusätzlich kann ein Strom und/oder eine oder die Spannung durch den Sensor und/oder die Faser unter Verwendung des magnetooptischen Kerr-Effekts erfasst sein oder werden. Es kann vorgesehen sein, dass durch den magnetooptischen Kerr-Effekt ein Magnetfeld erfasst werden kann, wodurch eine Spannung und/oder eine Stromstärke ermittelt sein oder werden kann.

In einigen Ausführungsformen kann zur Erfassung des Stroms und/oder für die Strommessung mittels der Verdet-Konstante und/oder den Farraday-Effekt auf die Stromstärke geschlossen werden. Dabei kann eine Drehung der Polaristionsebene von durch die Faser oder den Sensor geleitetem Licht in Abhängigkeit eines Magnetfelds, und/oder der Verdet-Konstante des Sensors und/oder der Faser, variieren, so dass aus dem Drehwinkel der Polarisationsebene das Magnetfeld und/oder der elektrische Strom bestimmbar ist. Die Verdet-Konstante des Sensors und/oder der Faser kann von der Wellenlänge des geleiteten Lichts abhängen, und/oder von dem Material des Sensors und/oder der Faser.

Der Messwert kann eine erfasste, bestimmte und/oder gemessene Vibration umfassen. Der Messwert kann einen erfassten, bestimmten und/oder gemessenen Schall umfassen. Der Messwert kann eine erfasste, bestimmte und/oder gemessene Lichtimpuls und/oder Teilentladung umfassen.

In einigen Ausführungsformen kann ein Referenzlicht bei oder für die Erfassung des Messwerts vorgesehen sein. Beispielsweise kann ein Laser ein entsprechendes Referenzlicht erzeugen. Das Referenzlicht kann durch eine oder die Faser geleitet sein oder werden.

Das Verfahren kann ohne großen Aufwand bei bereits vorhandenen und/oder eingesetzten elektromechanischen Energiewandlern nachgerüstet sein oder werden.

In einigen Ausführungsformen kann zusätzlich eine Messung des Stroms, z.B. einer Spannung und/oder einer Stromstärke, des elektromechanischen Energiewandlers mit der Fasersensorik und/oder den Sensoren möglich und/oder vorgesehen sein. In einigen Ausführungsformen kann alternativ oder zusätzlich eine Messung der Erwärmung und/oder inneren Temperatur im elektronischen Energiewandler möglich und/oder vorgesehen sein, z.B. mit den Sensoren. Eine Messung des Stroms und/oder der Erwärmung parallel und/oder gleichzeitig zur Messung von Teilentladung kann möglich und/oder vorgesehen sein, in einigen Ausführungsformen mit demselben Sensor und/oder der gleichen Faser. Beispielsweise kann eine Messung und/oder ein Bestimmen eines Auftretens von Teilentladungen durch faseroptische Detektion z.B. von Photonen erfolgen. Es kann vorgesehen sein, dass der Strom, und/oder die Erwärmung und/oder Temperatur, von einem zusätzlichen Sensor erfasst oder werden kann. Der zusätzliche Sensor muss nicht zwingend ein faseroptischer und/oder faserakustischer Sensor sein. In einigen Ausführungsformen kann der Strom, und/oder die Erwärmung und/oder Temperatur, alternativ oder zusätzlich aber auch von oder mit einem faseroptischer und/oder faserakustischer Sensor gemessen oder erfasst sein oder werden.

In einigen Ausführungsformen kann alternativ oder zusätzlich eine Messung eines oder des Stroms mit der Fasersensorik und/oder den Sensoren möglich und/oder vorgesehen sein. Eine Messung des Stroms kann eine Messung einer Spannung und/oder einer Stromstärke umfassen. Der Strom, und/oder die Spannung und/oder Stromstärke, kann ein Strom, und/oder eine Spannung und/oder Stromstärke, eines durch eine Wicklung, z.B. die Läuferwicklung und/oder die Statorwicklung fließenden elektrischen Stroms sein.

In einigen Ausführungsformen kann alternativ oder zusätzlich eine Messung einer Drehzahl des elektromechanischen Energiewandlers vorgesehen sein. Die Drehzahl kann eine Drehzahl eines Läufers des elektromechanischen Energiewandlers sein oder umfassen. Es kann vorgesehen, dass die Drehzahl von einem zusätzlichen Sensor erfasst sein oder werden kann. Der zusätzliche Sensor muss nicht zwingend ein faseroptischer und/oder faserakustischer Sensor sein. In einigen Ausführungsformen kann die Drehzahl alternativ oder zusätzlich aber auch von oder mit einem faseroptischer und/oder faserakustischer Sensor gemessen oder erfasst sein oder werden.

Alternativ oder zusätzlich kann eine oder die Drehzahl z.B. basierend auf erfassten Vibrationen und/oder Schall bestimmt sein oder werden. Das Klassifizieren kann eine Bestimmung der Drehzahl umfassen.

Es kann vorgesehen sein, dass der Zustand und/oder die Drehzahl durch eine Vibrationsanalyse bestimmt sein oder werden kann. In einigen Ausführungsformen kann bei der Vibrationsanalyse eine Amplitude und/oder Phase einer oder mehrerer Schwingungen oder Vibrationen bestimmt sein oder werden. Beispielsweise kann ein Spektrum erstellt sein oder werden, und/oder eine Transformation, z.B. eine Fourier-Transformation, eine Wavelet-Transformation oder dergleichen, durchgeführt sein oder werden kann.

Eine Messung und/oder eine Bestimmung eines Auftretens von Teilentladungen kann z.B. durch Vibrationsanalytik erfolgen und/oder vorgesehen sein. In einigen Ausführungsformen kann alternativ oder zusätzlich eine Messung, und/oder ein Bestimmen oder Ermittlung, eines Auftretens von Lagerschäden durch Veränderung des Spektrums und Erfassung durch die gleichen faserakustischen und/oder faseroptischer Sensoren erfolgen. Dabei kann sich eine Kostenersparnis durch Reduktion der Gesamtanzahl an Sensoren verglichen mit üblichen Lösungen ergeben.

In einigen Ausführungsformen kann eine Korrelation von akustischem und optischem Auftreten von Teilentladungen ermittelt und/oder bestimmt sein oder werden. Dadurch kann sich eine Erhöhung der Zuverlässigkeit der Detektion von Teilentladungen ergeben, z.B. im Elektromagnetisch hoch beanspruchten und gestörten Feldraum.

In einigen Ausführungsformen kann alternativ oder zusätzlich eine Korrelation von akustischem und/oder optischem und/oder elektrische gemessenen Auftreten von Teilentladungen erfolgen. Dadurch kann eine Erhöhung der Zuverlässigkeit der Detektion von Teilentladungen, z.B. im Elektromagnetisch hoch beanspruchten und gestörten Feldraum), erreicht sein.

Der elektromechanische Energiewandler kann ein Motor, insbesondere ein Elektromotor, sein oder aufweisen. Der elektromechanische Energiewandler kann ein Generator, insbesondere ein elektrischer Generator, sein oder aufweisen.

Der Motor kann ein Motor eines Elektrofahrzeugs, beispielsweise eines Elektroautos, sein.

In einigen Ausführungsformen kann beim Durchführen der Merkmalsextraktion eine Hüllkurve eines, mehrerer oder aller der digitalen Signale bestimmt werden. Alternativ oder zusätzlich kann beim Durchführen der Merkmalsextraktion eine Fouriertransformation, eine Wavelettransformation und/oder ein Templatematching durchgeführt werden.

Bei der Merkmalsextraktion mittels Hüllkurve kann in einigen Ausführungsformen eine Pulsweite und/oder Amplitude, beispielsweise einer Maximalamplitude, der Hüllkurve bestimmt sein oder werden. Das Merkmal kann z.B. die bestimmte Pulsweite und/oder Amplitude umfassen.

In einigen Ausführungsformen kann bei der Merkmalsextraktion eine Amplitude und/oder eine Pulsbreite, z.B. eine Impulsbreite, eines Signalverlaufs bestimmt sein oder werden. In einigen Ausführungsformen kann bei der Merkmalsextraktion Anzahl Lichtimpulse gezählt und/oder bestimmt sein oder werden.

Es kann vorgesehen sein, dass bei der Merkmalsextraktion ein Photomultiplier, ein Multi-Pixel-Photon-Counter (MPPC) oder dergleichen verwendet sein oder werden kann.

Die Merkmalsextraktion kann ähnlich wie die in der DE 10 2020 119 012 A1 offenbart ausgebildet sein.

Beim Bestimmen eines Zustands und/oder einer Fehlerursache des elektromechanischen Energiewandlers entsprechend der Klassifikation kann eine in dem elektromechanischen Energiewandler auftretende Teilentladung erkannt und/oder bestimmt werden.

Durch die Merkmalsextraktion kann eine oder die nachfolgende Klassifizierung genauer erfolgen, und der Zustand und/oder eine Fehlerursache genauer identifiziert werden. Durch die Merkmalsextraktion können an oder für verschiedene elektromechanische Energiewandler, z.B. solche verschiedener Art und/oder Typs, vergleichbar sein und/oder vergleichbar gemacht werden, so dass eine oder die nachfolgende Klassifizierung verbessert sein oder werden kann, und/oder sogar für verschiedene Arten und/oder Typen elektromechanischer Energiewandler ohne weitere Anpassungen erfolgen kann.

In einigen Ausführungsformen kann beim Klassifizieren das oder die extrahierten Merkmale gruppiert werden.

Es kann vorgesehen sein, dass von mindestens einem der Sensoren ein Messwert an oder in einer Läuferwicklung und/oder einer Nut eines Läufers des elektromechanischen Energiewandlers erfasst werden kann. Alternativ oder zusätzlich kann von mindestens einem der Sensoren ein Messwert an oder in einer Statorwicklung und/oder einer Nut eines Stators des elektromechanischen Energiewandlers erfasst werden. Damit kann ein oder der Sensor, und/oder eine Faser eines Sensors, an kritischen Stellen der Wicklungen, z.B. an oder in einem Wickelkopf oder an, in oder über einer Nut, positioniert sein oder werden.

In einigen Ausführungsformen kann ein Sensor oder eine Faser mit einer Wicklung und/oder einer Spule gewickelt und/oder verwunden sein. In einigen Ausführungsformen kann vorgesehen sein, dass ein oder der Sensor freiliegend angeordnet sein und/oder verlaufen kann. Mit "freiliegend" kann gemeint sein, dass ein Sensor und/oder eine Faser beispielsweise nicht in eine Isolierung eingebettet sein kann, sondern auf einer Außenseite der Isolierung angeordnet sein kann.

Es kann vorgesehen sein, dass Messwerte von mindestens zwei oder mehreren Sensoren erfasst werden können, wobei mindestens zwei der Sensoren unterschiedliche Bandbreiten haben können, so dass Messwerte innerhalb einer kombinierten Bandbreite der mindestens zwei Sensoren erfassbar sein können. Beispielsweise kann die Bandbreite eines Sensors Infraschall und die Bandbreite eines anderen Sensors Ultraschall umfassen. Durch eine Kombination von Sensoren unterschiedlicher Bandbreite kann damit die Breite der erfassten Messwerte, und/oder die Genauigkeit der Klassifizierung, erhöht sein oder werden.

Nach dem Erfassen eines Messwertes, und/oder nach dem Erfassen der Messwerte, kann eine analoge Signalvorverarbeitung durchgeführt werden. In einigen Ausführungsformen kann der oder die Messwerte mit einem Anti-Aliasing-Filter und/oder einem Verstärker vorverarbeitet werden.

Nach dem Umwandeln in ein digitales Signal kann eine digitale Signalvorverarbeitung des digitalen Signals durchgeführt werden. Die digitale Signalvorverarbeitung kann ein Durchführen einer Rauschreduzierung umfassen. Es kann vorgesehen sein, dass die digitale Signalvorverarbeitung für jedes digitale Signal separat durchgeführt werden kann,

Es kann vorgesehen sein, dass eine kanalübergreifende digitale Signalvorverarbeitung durchgeführt werden kann. Die kanalübergreifende digitale Signalvorverarbeitung kann ein Durchführen einer Rauschreduzierung umfassen. Bei der kanalübergreifenden digitalen Signalvorverarbeitung können mindestens zwei digitale Signale berücksichtigt werden. In einigen Ausführungsformen kann die kanalübergreifende digitale Signalvorverarbeitung nach der digitalen Signalvorverarbeitung durchgeführt sein oder werden.

Bei der Merkmalsextraktion und/oder der Klassifizierung kann ein Steuersignal des elektromechanischen Energiewandlers berücksichtigt werden.

Bei der Merkmalsextraktionen können mindestens zwei digitale Signale zusammengeführt werden. Aus den mindestens zwei zusammengeführten digitalen Signalen kann mindestens ein Merkmal extrahiert werden.

Bei dem Verfahren kann der Klassifikator zudem eine Zeitinformation als Eingangsgröße umfassen. Damit kann der Klassifikator beispielsweise der erstellten Klassifikation und/oder dem bestimmten Zustand und/oder der Fehlerursache einen Zeitstempel zuordnen. In einigen Ausführungsformen kann der Klassifikator zeitliche Verläufe und/oder Änderungen der Klassifikation, und/oder des Zustands und/oder der Fehlerursache, ermitteln und/oder bestimmen.

Alternativ oder zusätzlich kann ein zweiter Klassifikator eine weitere Klassifikation basierend auf dem oder den extrahierten Merkmalen durchführen. Alternativ oder zusätzlich kann ein oder der zweiter Klassifikator eine weitere Klassifikation basierend auf der von dem Klassifikator erstellten Klassifikation vornehmen. Die weitere Klassifikation kann nach oder bei dem Durchführen der Klassifikation erfolgen. Der zweite Klassifikator kann zudem eine Zeitinformation als Eingangsgröße umfassen. Alternativ oder zusätzlich kann ein oder der zweite Klassifikator zeitliche Änderungen des Zustands ermitteln. Damit kann der zweite Klassifikator beispielsweise der erstellten Klassifikation und/oder dem bestimmten Zustand und/oder der Fehlerursache einen Zeitstempel zuordnen. In einigen Ausführungsformen kann der Klassifikator zeitliche Verläufe und/oder Änderungen der Klassifikation, und/oder des Zustands und/oder der Fehlerursache, ermitteln und/oder bestimmen. In einigen Ausführungsformen kann der Klassifikator und der zweite Klassifikator kombiniert sein oder werden.

Der bestimmte Zustand und/oder die Fehlerursache kann an ein weiteres Gerät übermittelt werden. Das weitere Gerät kann ein Human-Machine-Interface, ein Display, ein Computergerät, ein Peripheriegerät und/oder ein Netzwerkgerät sein oder aufweisen.

Es kann vorgesehen sein, dass basierend auf dem ermittelten Zustand und/oder der Fehlerursache, und/oder deren zeitliche Verläufe und/oder zeitliche Änderungen, ein Wartungszeitpunkt prognostiziert sein oder werden kann. In einigen Ausführungsformen kann eine Fernwartung des elektromechanischen Energiewandlers vorgesehen sein, und/oder durchgeführt sein oder werden.

In einigen Ausführungsformen kann eine Steuerung und/oder Regelung des elektromechanischen Energiewandlers basierend auf dem ermittelten Zustand und/oder Fehlerursache vorgesehen sein. Bei der Steuerung und/oder Regelung kann eine Drehzahl des elektromechanischen Energiewandlers, insbesondere eines Läufers des elektromechanischen Energiewandlers, berücksichtigt sein oder werden.

Ein weiterer Aspekt der Erfindung betrifft ein System zur Zustandsanalyse eines elektromechanischen Energiewandlers, aufweisend
- einen elektromechanischen Energiewandler, bevorzugt einen Motor oder einen Generator;
- mindestens einen Sensor, wobei der mindestens eine Sensor ein faseroptischer und/oder faserakustischer Sensor ist oder aufweist, und wobei der mindestens eine Sensor dazu eingerichtet ist, einen jeweiligen Messwert des elektromechanischen Energiewandlers zu erfassen, wobei der mindestens eine Sensor dazu eingerichtet ist, beim Erfassen des jeweiligen Messwerts eines oder mehrere aus Vibration, Schall, Lichtimpulsen, Temperatur, Drehzahl, translatorische oder rotatorische Bewegung, elektrischer Spannung und/oder Stromstärke zu erfassen;
- mindestens einen A/D-Wandler, der dazu eingerichtet ist, einen oder mehrere Messwerte in ein jeweiliges digitales Signal umzuwandeln;
- Eine Merkmalsextraktionseinheit, die dazu eingerichtet ist, mindestens ein Merkmal aus dem oder den digitalen Signalen zu extrahieren;
- einen Klassifikator, der dazu eingerichtet ist, eine Klassifikation der extrahierten Merkmale durchzuführen und entsprechend der Klassifikation einen Zustand und/oder eine Fehlerursache des elektromechanischen Energiewandlers zu bestimmen, bevorzugt eine in dem elektromechanischen Energiewandler auftretende Teilentladung zu erkennen und/oder zu bestimmen.

Das System kann dazu eingerichtet sein, das Verfahren durchzuführen. Das Verfahren kann mit und/oder von dem System ausgeführt sein oder werden.

In einigen Ausführungsformen kann die Merkmalsextraktionseinheit dazu eingerichtet sein, eine Hüllkurve des digitalen Signals zu bestimmen. Alternativ oder zusätzlich kann die Merkmalsextraktionseinheit dazu eingerichtet sein, eine Fouriertransformation, eine Wavelettransformation und/oder ein Templatematching durchzuführen.

Der Klassifikator kann dazu eingerichtet sein, eine in dem elektromechanischen Energiewandler auftretende Teilentladung zu erkennen und/oder zu bestimmen.

Der elektromechanischen Energiewandler kann einen Stator und einen Läufer aufweisen. Mindestens einer der Sensoren kann in einer Nut des Stators und/oder einer Nut des Läufers angeordnet sein. Alternativ oder zusätzlich kann mindestes einer der Sensor in einer Läuferwicklung des Läufers und/oder einer Statorwicklung des Stators integriert sein. Beispielsweise kann ein oder der Sensor in eine Wicklung und/ eine Spule oder dergleichen eingewickelt sein. In einigen Ausführungsformen kann vorgesehen sein, dass ein oder der Sensor freiliegend angeordnet sein und/oder verlaufen kann. Mit "freiliegend" kann gemeint sein, dass ein Sensor und/oder eine Faser beispielsweise nicht in eine Isolierung eingebettet sein kann, sondern auf einer Außenseite der Isolierung angeordnet sein kann.

Das System kann mindestens zwei Sensoren aufweisen. Mindestens zwei der Sensoren können unterschiedliche Bandbreiten haben, so dass Messwerte innerhalb einer kombinierten Bandbreite der Sensoren erfassbar sein können. Beispielsweise kann die Bandbreite eines Sensors Infraschall und die Bandbreite eines anderen Sensors Ultraschall umfassen.

Das System kann eine Erkennungseinheit aufweisen. Die Erkennungseinheit kann ein Interferometer sein oder aufweisen.

Das System kann eine analoge Signalvorverarbeitungsvorrichtung aufweisen. In einigen Ausführungsformen kann die analoge Signalvorverarbeitungsvorrichtung eines oder mehrere aus Verstärker, Anti-Aliasing-Filter und/oder Interferometer aufweisen kann. Die analoge Signalvorverarbeitungsvorrichtung kann mit mindestens einem der Sensoren und/oder mindestens einem der A/D-Wandler verbunden sein.

Alternativ oder zusätzlich kann das System eine digitale Signalvorverarbeitungseinheit umfassen. Die digitale Signalvorverarbeitungseinheit kann mit mindestens einem der A/D-Wandler und der Merkmalsextraktionseinheit verbunden sein.

Das System kann einen zweiten Klassifikator aufweisen. Der zweite Klassifikator kann dazu eingerichtet sein, zeitliche Änderungen des Zustands zu ermitteln. Alternativ oder zusätzlich kann der zweite Klassifikator dazu eingerichtet sein, nach dem Durchführen der Klassifikation eine weitere Klassifikation basierend auf dem oder den extrahierten Merkmalen durchzuführen, wobei der zweite Klassifikator zudem eine Zeitinformation als Eingangsgröße umfassen kann. Die weitere Klassifikation kann nach oder bei dem Durchführen der Klassifikation erfolgen. Damit kann der zweite Klassifikator beispielsweise der erstellten Klassifikation und/oder dem bestimmten Zustand und/oder der Fehlerursache einen Zeitstempel zuordnen. In einigen Ausführungsformen kann der Klassifikator zeitliche Verläufe und/oder Änderungen der Klassifikation, und/oder des Zustands und/oder der Fehlerursache, ermitteln und/oder bestimmen. In einigen Ausführungsformen kann der Klassifikator und der zweite Klassifikator kombiniert sein oder werden.

Das System kann ein weiteres Gerät aufweisen. Das weitere Gerät kann dazu eingerichtet sein, den bestimmten Zustand und/oder die Fehlerursache auszugeben. Das weitere Gerät kann ein Human-Machine-Interface, ein Display, ein Peripheriegerät und/oder ein Computergerät sein oder aufweisen.

Das System kann eine Steuervorrichtung aufweisen. Die Steuervorrichtung kann dazu eingerichtet sein, den elektromechanischen Energiewandler zu steuern und/oder zu regeln. Die Steuervorrichtung kann basierend auf dem ermittelten Zustand und/oder der ermittelten Fehlerursache den elektromechanischen Energiewandler steuern und/oder regeln.

### Beschreibung von Ausführungsbeispielen

Im Folgenden werden weitere Ausführungsbeispiele unter Bezugnahme auf Figuren einer Zeichnung näher erläutert. Hierbei zeigen:
Fig. 1 eine beispielhafte Ausführungsform eines erfindungsgemäßen Systems;
Fig. 2 eine weitere beispielhafte Ausführungsform eines erfindungsgemäßen Systems; und
Fig. 3 eine beispielhafte Ausführungsform eines elektromechanischen Energiewandlers.

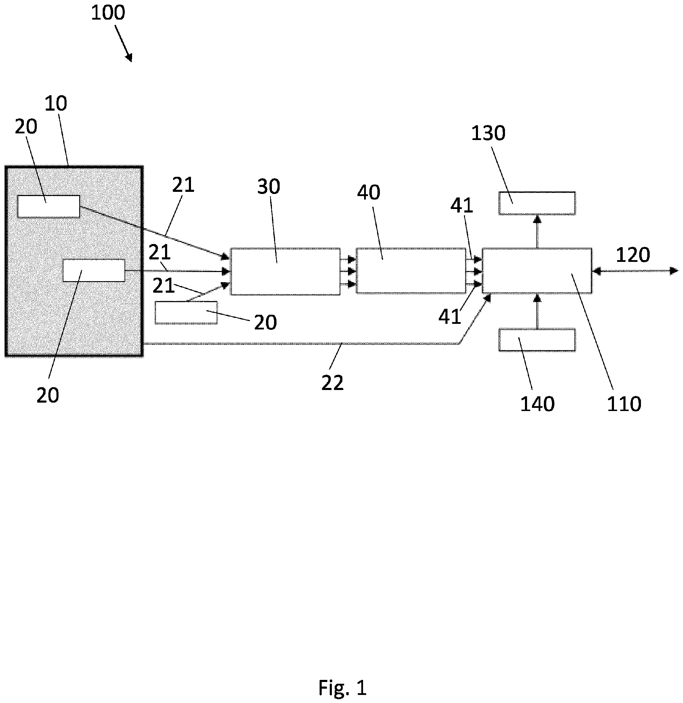

Fig. 1 zeigt eine beispielhafte Ausführungsform eines erfindungsgemäßen Systems 100.

Das System 100 weist einen elektromechanischen Energiewandler 10 auf. Der elektromechanische Energiewandler 10 kann ein Motor sein oder aufweisen. Der elektromechanische Energiewandler 10 kann ein Generator sein oder aufweisen.

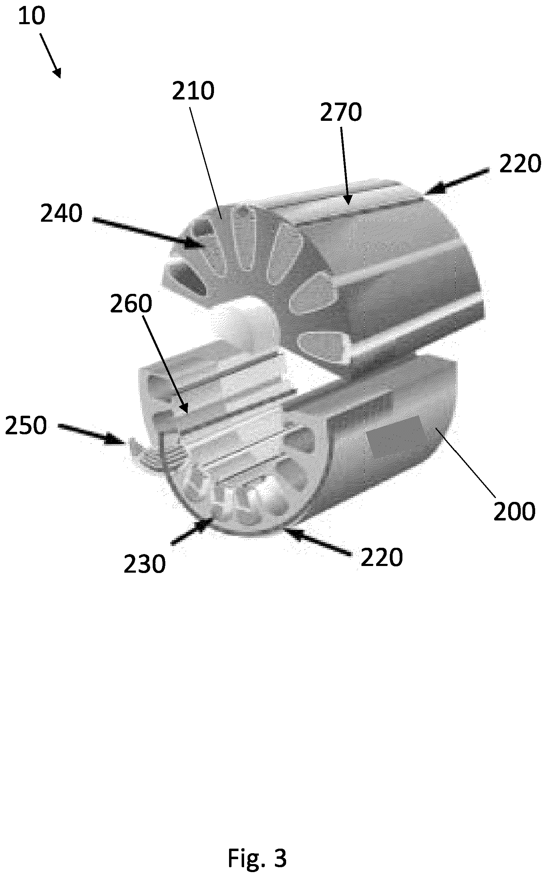

Der elektromechanische Energiewandler 10 und/oder der Motor kann dazu eingerichtet sein, elektrische Energie in mechanische Energie umzuwandeln. Der elektromechanische Energiewandler 10 und/oder der Generator kann dazu eingerichtet sein, mechanische Energie in elektrische Energie umzuwandeln. Ein beispielhafter elektromechanischer Energiewandler 10 ist in Fig. 3 gezeigt.

Das System 100 weist einen Sensor 20 auf. Der Sensor 20 ist ein faseroptischer Sensor und/oder ein faserakustischer Sensor. Der Sensor 20 kann einen Messwert 21 erfassen.

Der Sensor 20 kann Vibrationen, Schall, z.B. Körperschall und/oder Luftschall, und/oder Lichtimpulse aufnehmen und/oder erfassen. Der Sensor 20 kann alternativ oder zusätzlich eine Temperatur, Drehzahl, elektrische Spannung und/oder Stromstärke aufnehmen und/oder erfassen.

Der Messwert 21 kann ein analoger Messwert 21 sein. Der Messwert 21 kann ein analoges Signal sein oder aufweisen.

Es kann vorgesehen sein, dass das System 100 mehr als einen Sensor 20 aufweisen kann.

Ein oder der Sensor 20, insbesondere ein oder der faseroptische und/oder faserakustische Sensor, kann eine Faser aufweisen. Der Sensor 20 kann eine Glasfaser und/oder Kunststofffaser aufweisen. Die Faser kann eine Glasfaser oder eine Kunststofffaser sein. Der Sensor 20 und/oder die Faser kann einen Lichtwellenleiter umfassen. Die Faser kann dazu eingerichtet sein, ihre Lichtleitungseigenschaft, z.B. eine Beugung, ein Reflexionsvermögen, eine Streuung, eine Interferenz, eine Transmission, eine Wellenlänge, eine Dehnung, eine Rückstreuung oder dergleichen, zu verändern, wenn sie eine Vibration und/oder Schall erfasst, und/oder ihre Temperatur ändert. Beispielsweise kann sich die Lichtwelleneigenschaft durch eine (ggf. lokale) Dehnung, Längenänderung und/oder Verformung der Faser 20, z.B. der Glasfaser, infolge von Vibrationen und/oder Schall, und/oder Temperaturvariationen, ergeben. Die veränderte Lichtleitungseigenschaft kann erfasst werden, beispielsweise von einer Erfassungseinheit und/oder mit einem Interferometer. Die erfasste veränderte Lichtleitungseigenschaft kann ein Maß für die Vibration und/oder den Schall, und/oder eine Temperatur, sein, und/oder diesen charakterisieren oder bestimmbar machen.

In einigen Ausführungsformen kann der Sensor 20, und/oder die Faser, einen Lichtimpuls, beispielsweise ein oder mehrere Photonen, erfassen, die z.B. bei einer Teilentladung auftreten und/oder entstehen können. Der Lichtimpuls kann von dem Sensor 20 und/oder der Faser geleitet werden. Der Lichtimpuls kann von einer Erfassungseinheit, z.B. einem Interferometer, erfasst sein oder werden. Der erfasste Lichtimpuls kann ein Maß für eine Teilentladung sein, und/oder diese charakterisieren oder bestimmbar machen. Bei einer Teilentladung kann ein Lichtimpuls auftreten und/oder erzeugt sein oder werden, beispielsweise an oder in einer Isolierung.

Prinzipiell kann ein einzelner Sensor 20 ausreichen, um das erfindungsgemäße Verfahren durchzuführen. Durch eine höhere Anzahl Sensoren 20, insbesondere eine höhere Anzahl Vibrations- und Schallsensoren, kann die Qualität der Zustandsbestimmung erhöht werden. Beispielsweise kann durch Verwendung mehrerer Sensoren 20 prinzipiell das Signal-Rausch-verhältnis verbessert werden, mit dem die Messsignale 21 erfasst sein oder werden können.

In einigen Ausführungsformen kann die Bandbreite erhöht werden, mit der die Messwerte 21, insbesondere Vibrationen bzw. Schallsignale, aufgenommen werden können. Eine Erhöhung der Bandbreite kann beispielsweise dadurch erreicht sein oder werden, dass die Bänder unterschiedlicher Sensoren 21 miteinander kombiniert sein oder werden können. So lässt sich z.B. durch Vibrationen emittierte Infraschall parallel zum Ultraschall erfassen, indem man zwei Sensoren 20, insbesondere Vibrationssensoren, mit jeweils unterschiedlichem Frequenzband zusammenwirken.

Zudem können sich, wenn mehrerer Sensoren 20 vorgesehen sind, über Laufzeiteffekte die für ein Vibrations-/Schallsignal verantwortlichen Quellen lokalisieren lassen. Bei Kenntnis des Orts und/oder der Quelle kann eine Ursache eines Vibrationsereignisses oder eines Schallereignisses genauer und/oder leichter identifiziert und/oder bestimmt sein oder werden.

In einigen Ausführungsformen kann eine analoge Signalvorverarbeitung vorgesehen sein. Das System 100 kann eine analoge Signalvorverarbeitungsvorrichtung 30 aufweisen.

Die analoge Signalvorverarbeitungsvorrichtung 30 kann mit mindestens einem, mehreren oder allen Sensoren 20 verbunden sein. Die analoge Signalvorverarbeitungsvorrichtung 30 kann Messwerte 21 von einem oder mehreren Sensoren 20 empfangen. In einigen Ausführungsformen kann ein von einem Sensor 20 erfasster Messwert 21 ein Eingangssignal der analogen Signalvorverarbeitungsvorrichtung 30 sein.

Die analoge Signalvorverarbeitungsvorrichtung kann einen Verstärker aufweisen. Die analoge Signalvorverarbeitung kann eine Verstärkung eines oder mehrerer Messwerte 21 umfassen.

Die analoge Signalvorverarbeitungsvorrichtung 30 kann einen Anti-Aliasing-Filter aufweisen und/oder dazu eingerichtet sein, ein Anti-Aliasing durchzuführen. Die Messwerte 21 können den Anti-Aliasing-Filter durchlaufen, und/oder es kann ein Anti-Aliasing der Messwerte 21 durchgeführt sein oder werden.

Das System 100 und/oder die analoge Signalvorverarbeitungsvorrichtung 30 kann ein Interferometer aufweisen. Das Interferometer kann beispielsweise ein Michelson-Interferometer sein oder aufweisen. Das Interferometer kann beispielsweise ein Sagnac-Interferometer sein oder aufweisen.

Das System 100 weist mindestens einen Analog/Digital-Wandler (A/D-Wandler) 40 auf. Der A/D-Wandler 40 ist dazu eingerichtet, einen oder mehrere analoge Signale in entsprechende digitale Signale umzuwandeln. Die von dem oder den A/D-Wandlern 40 empfangenen analogen Signale können den durch die analoge Signalvorverarbeitung verarbeiteten Messwerten 21 entsprechen. Es kann vorgesehen sein, dass der oder die A/D-Wandler 40 mit der analogen Signalvorverarbeitungsvorrichtung 30 verbunden sein, so dass die aus der analogen Signalvorverarbeitungsvorrichtung 30 ausgegebenen Signale mindestens einem A/D-Wandler 40 zugeführt sein oder werden können. Ein aus der analogen Signalvorverarbeitungsvorrichtung 30 ausgegebenes Signal kann ein Eingangssignals mindestens eines A/D-Wandlers 40 sein.

In einigen Ausführungsformen kann aber auch, z.B. wenn eine analoge Signalverarbeitung nicht vorgesehen oder nicht vorhanden ist, ein von einem oder dem Sensor 21 ausgegebenes Signal, insbesondere ein von einem Sensor 20 erfasster Messwert 21, unmittelbar mindestens einem A/D-Wandler 40 zugeführt sein oder werden. In einigen Ausführungsformen kann ein von einem Sensor 20 erfasster Messwert 21 ein Eingangssignal mindestens eines A/D-Wandler 40 sein.

Mit dem A/D-Wandler 40 wird ein oder mehrere Messwerte 21 in ein entsprechendes digitales Signal 41 umgewandelt. In einigen Ausführungsformen kann ein Multiplex-Verfahren vorgesehen sein. Bei dem Multiplex-Verfahren können mehrere oder alle Messwerte 21 in entsprechende digitale Signale 21 mit einem A/D-Wandler 40 umgewandelt werden. Alternativ oder zusätzlich können mehrere A/D-Wandler 40 vorgesehen sein, die Messwerte 21 parallel in entsprechende digitale Signale 21 umwandeln können.

Ein digitales Signal 41 kann eine digitale Repräsentation eines Messwerts 21 sein. Ein digitales Signal 41 kann einem digitalen Messwert entsprechen.

Das System 100 kann eine Verarbeitungseinheit 110 aufweisen. Die Verarbeitungseinheit 110 kann ein Computergerät sein oder aufweisen. Die Verarbeitungseinheit 110 kann einen Prozessor oder mehrere Prozessoren aufweisen. Ein Prozessor kann z.B. eine CPU, ein Mikroprozessor (MPU), ein digitaler Signalprozessor (DSP) und/oder ein anderer geeigneter Spezialprozessor sein oder aufweisen. Die Verarbeitungseinheit 110 kann in einigen Ausführungsformen ein eingebettetes System (embedded system) und/oder ein integrierter Schaltkreis (IC) sein oder aufweisen. Alternativ oder zusätzlich kann die Verarbeitungseinheit 110 einen oder mehrere programmierbare Logikbausteine aufweisen. Ein programmierbarer Logikbaustein kann ein Complex Programmable Logic Devices (CPLD) sein oder aufweisen. Ein programmierbarer Logikbaustein kann ein Field Programmable Gate Array (FPGA) sein oder aufweisen.

Die Verarbeitungseinheit 110 kann dazu eingerichtet sein, einen Zustand des elektromechanischen Energiewandlers 10 zu bestimmen. Die Verarbeitungseinheit 110 kann dazu eingerichtet sein, eine Fehlerursache des elektromechanischen Energiewandlers zu bestimmen.

Das oder die digitalen Signale 41 können Eingangssignale der Verarbeitungseinheit 110 sein. In einigen Ausführungsformen kann vorgesehen sein, dass ein Steuersignal 22 des elektromechanischen Energiewandlers 10 der Verarbeitungseinheit 110 zugeführt sein oder werden kann. Das Steuersignal 22 kann beispielsweise von einem Port 42 und/oder einem A/D-Wandler ausgegeben sein oder werden.

Die Verarbeitungseinheit 110 kann dazu eingerichtet sein, dass oder die digitalen Signale 41 auszuwerten, und basierend auf der Auswertung eines Zustands und/oder eine Fehlerursache des elektromechanischen Energiewandlers 10 zu bestimmen. In einigen Ausführungsformen kann Verarbeitungseinheit 110 eine in dem elektromechanischen Energiewandler 10 auftretende Teilentladung zu erkennen. Insbesondere kann die Verarbeitungseinheit 110 dazu eingerichtet sein, eine in eine Wicklung, beispielsweise in einem Wicklungskopf, einer Spule oder einem Spulenstab des elektromechanischen Energiewandlers 10, z.B. in einem Stator oder einem Läufer, zu erfassen.

In einigen Ausführungsformen kann bei der Bestimmung des Zustands des elektromechanischen Energiewandlers 10, und/oder einer Fehlerursache, ein oder das Steuersignal 22 des elektromechanischen Energiewandlers 10 berücksichtigt sein oder werden. Der elektromechanische Energiewandler 10 kann eine Steuervorrichtung umfassen, die dazu eingerichtet sein kann, den elektromechanischen Energiewandler 10 zu steuern und/oder zu regeln. Die Steuervorrichtung kann dazu eingerichtet sein, eines oder mehrere Steuersignale 22 zu erzeugen. In einigen Ausführungsformen kann die Verarbeitungseinheit 110 die Steuervorrichtung umfassen oder aufweisen.

Es kann vorgesehen sein, dass ein oder mehrere Steuersignale 22 des elektromechanischen Energiewandlers 10 bei der Bestimmung des Zustands und/oder der Fehlerursache berücksichtigt werden und/oder in die Bestimmung einfließen.

Steuersignale 22 können beispielsweise den elektromechanischen Energiewandler 10 steuern und/oder regulär dafür verantwortlich sein, gewisse Aktionen des elektromechanischen Energiewandlers 10 auszulösen. Beispielsweise kann ein Steuersignal 22 ein Startsignal sein oder umfassen, und/oder eine Leistung des elektromechanischen Energiewandlers 10, z.B. eine Leistung der zu wandelnden Energie und/oder der gewandelten Energie zu steuern oder zu regeln. In einigen Ausführungsformen kann ein Steuersignal 22 alternativ oder zusätzlich eine dem elektromechanischen Energiewandler 10 zuzuführende Menge Strom, z.B. pro Zeiteinheit, umfassen.

Ein Abgriff eines Steuersignals 22 oder eine Messung an einer Stromzuleitung des elektromechanischen Energiewandlers 10 kann beispielsweise mit zusätzlichen Sensoren erfolgen. Einer, mehrere oder alle zusätzlichen Sensoren können nichtmechanische Sensoren sein oder aufweisen.

Das Steuersignal 22 kann von der Verarbeitungseinheit 110 genutzt werden, um beispielsweise erfasste Messwerte, z.B. Temperaturen, Vibrationen und/oder Schallemissionen, und/oder elektrische Spannungen und/oder Stromstärken, dem elektromechanischen Energiewandler 10 und/oder anderen beteiligten Komponenten zuzuordnen.

Bei einer Berücksichtigung des oder der Steuersignale 22 kann eine Ursachenerkennung sehr einfach implementiert werden und sehr zuverlässig zu sein. Insbesondere können auch Fehler erkannt werden können, die sich durch das Ausbleiben von Vibrationen oder Schallereignissen manifestieren. Wenn z.B. der elektromechanische Energiewandler 10 laufen sollte. Wie z.B. durch ein entsprechendes Steuersignal 22 impliziert, aber keinerlei Messwerte wie z.B. Vibrationen und/oder Schallereignisse erfasst werden, so kann der elektromechanische Energiewandler 10 und/oder die Steuervorrichtung, z.B. eine Motorsteuerung, defekt sein. Ebenso kann in einigen Ausführungsformen auf die Drehung bzw. Drehzahl des elektromechanischen Energiewandlers 10, beispielsweise eines Läufers, geschlossen werden. Beispielsweise kann basierend auf erfassten und/oder bestimmten Vibrationen und/oder Schall die Drehzahl des elektromechanischen Energiewandlers 10 bestimmt sein oder werden, oder zumindest abgeschätzt sein oder werden. Alternativ oder zusätzlich kann die Drehzahl in einigen Ausführungsformen von oder mit einem Sensor ermittelt und/oder erfasst sein oder werden.

Ebenso kann in einigen Ausführungsformen auf die translatorische und rotatorische Bewegung des elektromechanischen Energiewandlers 10, geschlossen werden. Beispielsweise kann basierend auf erfassten und/oder bestimmten Vibrationen und/oder Schall die Bewegung des elektromechanischen Energiewandlers 10 bestimmt sein oder werden, oder zumindest abgeschätzt sein oder werden. Alternativ oder zusätzlich kann die Bewegung in einigen Ausführungsformen von oder mit einem Sensor ermittelt und/oder erfasst sein oder werden.

In einigen Ausführungsformen kann die ermittelte, bestimmte und/oder erfasste Drehzahl mit einer von der Steuerung vorgegebenen Drehzahl verglichen sein oder werden. Die ermittelte, bestimmte und/oder erfasste Drehzahl kann mit einer Soll-Drehzahl verglichen sein oder werden. Bei Abweichungen, und/oder z.B. bei Überschreiten einer Differenz, ein Fehler des elektromechanischen Energiewandlers 10 vorliegen und/oder identifiziert sein oder werden.

Alternativ oder zusätzlich kann eine ermittelte, bestimmte und/oder erfasste Temperatur mit einer Soll-Temperatur verglichen sein oder werden. Bei Abweichungen, und/oder z.B. bei Überschreiten einer Differenz, ein Fehler des elektromechanischen Energiewandlers 10 vorliegen und/oder identifiziert sein oder werden. In einigen Ausführungsformen kann eine Erwärmung und/oder Abkühlung des elektromechanischen Energiewandlers 10 bestimmt sein oder werden, beispielsweise aus oder mit erfassten oder bestimmten Termperaturverläufen.

Alternativ oder zusätzlich kann eine ermittelte, bestimmte und/oder erfasste elektrische Spannung und/oder Stromstärke eines elektrischen Stroms mit einer entsprechenden Soll-Spannung und/oder einer Soll-Stromstärke, bzw. einem Soll-Strom, verglichen sein oder werden. Bei Abweichungen, und/oder z.B. bei Überschreiten einer Differenz, ein Fehler des elektromechanischen Energiewandlers 10 vorliegen und/oder identifiziert sein oder werden.

Es kann vorgesehen sein, dass der elektromechanische Energiewandler 10 basierend auf oder mit dem ermittelten Zustand und/oder der ermittelten Fehlermeldung gesteuert und/oder geregelt sein oder werden kann. Beispielsweise kann der ermittelte Zustand und/oder die ermittelte Fehlermeldung an eine oder die Steuervorrichtung übermittelt sein oder werden, und die Steuervorrichtung entsprechende Steuersignale und/der Regelsignale erzeugen.

In einigen Ausführungsformen kann auch eines oder mehrere aus erfasster und/oder bestimmter elektrischen Spannung, elektrischem Strom, Drehzahl und/oder Temperatur an die Steuervorrichtung übermittelt sein oder werden. Die elektrische Spannung, Stromstärke, elektrischer Strom, Drehzahl, Bewegung und/oder Temperatur kann bei der Steuerung und/oder Regelung berücksichtigt sein oder werden.

In einigen Ausführungsformen kann vorgesehen sein, dass der bestimmte Zustand und/oder Fehlerursache durch eine Ausgabeeinheit 130 kommuniziert sein oder werden können. Das System 100 kann die Ausgabeeinheit 130 umfassen. Die Verarbeitungseinheit 110 kann mit der Ausgabeeinheit 130 verbunden sein. Die Ausgabeeinheit 130 kann ein Peripheriegerät sein oder aufweisen. Die Ausgabeeinheit 130 kann ein Human-Machine-Interface sein oder aufweisen.

Durch die Ausgabeeinheit 130 kann beispielsweise einem Wartungstechniker Messungen, Messwerte 21, digitalen Signalen 41, bestimmte Zustände und/oder Fehlerursachen mitgeteilt sein oder werden.

Die Ausgabeeinheit 130 kann ein Display sein oder aufweisen. Das Display kann den Zustand und/oder eine Fehlerursache des elektromechanischen Energiewandlers 10 darstellen und/oder anzeigen.

In einigen Ausführungsformen kann die Ausgabeeinheit 130 eine oder mehrere LEDs oder andere Anzeigeeinheiten umfassen, die z.B. in Abhängigkeit des Zustands und/oder der Fehlerursache angesteuert sein oder werden können, beispielsweise in Abhängigkeit des Zustands und/oder der Fehlerursache unterschiedlich leuchten oder blinken können, und/oder Licht mit einer unterschiedlichen Farbe ausstrahlen können.

In einigen Ausführungsformen kann die Ausgabeeinheit 130 einen Lautsprecher oder dergleichen umfassen, der z.B. in Abhängigkeit des Zustands und/oder der Fehlerursache einen unterschiedlichen Ton, ein unterschiedliches akustisches Signal und/oder eine unterschiedliche Durchsage ausgeben kann.

In einigen Ausführungsformen kann eine Eingabeschnittstelle 140 vorgesehen sein. Die Eingabeschnittstelle 140 kann z.B. eine Tastatur, ein Touchpad und/oder ein Touchscreen sein oder aufweisen.

Durch die Eingabeschnittstelle 140 kann beispielsweise ein Wartungstechniker Details von Messungen, Messwerte 21, digitalen Signalen 41, bestimmten Zuständen und/oder Fehlerursachen abrufen.

In einigen Ausführungsformen kann eine Netzwerkverbindung 120 vorgesehen sein, mit der das System 100 und/oder die Verarbeitungseinheit 110 mit einem weiteren Gerät verbunden sein oder werden kann. Über die Netzwerkverbindung 120 können bestimmte Zustände und/oder Fehlerursachen an das weitere Gerät übermittelt sein oder werden.

Das weitere Gerät kann beispielsweise ein Server, z.B. ein Cloud-Server, sein oder aufweisen.

Die Verarbeitungseinheit 110 kann in einigen Ausführungsformen eine oder mehrere digitale Signalvorverarbeitungseinheiten 50, eine oder mehrere weitere digitale Signalvorverarbeitungseinheiten 60, eine oder mehrere Merkmalsextraktionseinheiten 70 und einen oder mehrere Klassifikatoren 80 umfassen.

In einigen Ausführungsformen kann eine oder die digitale Signalvorverarbeitungseinheit 50 softwarebasiert implementiert sein, und/oder das System 100 und/oder die Verarbeitungseinheit 110 dazu eingerichtet sein, eine Software auszuführen, die eine oder die digitale Signalvorverarbeitungseinheit 50 implementiert. In einigen Ausführungsformen kann eine oder die weitere digitale Signalvorverarbeitungseinheit 60 softwarebasiert implementiert sein, und/oder das System 100 und/oder die Verarbeitungseinheit 110 dazu eingerichtet sein, eine Software auszuführen, die eine oder die weitere digitale Signalvorverarbeitungseinheit 60 implementiert. In einigen Ausführungsformen kann eine oder die weitere Merkmalsextraktionseinheit 70 softwarebasiert implementiert sein, und/oder das System 100 und/oder die Verarbeitungseinheit 110 dazu eingerichtet sein, eine Software auszuführen, die eine oder die Merkmalsextraktionseinheit 70 implementiert. In einigen Ausführungsformen kann einer oder der Klassifikator 80 softwarebasiert implementiert sein, und/oder das System 100 und/oder die Verarbeitungseinheit 110 dazu eingerichtet sein, eine Software auszuführen, die einen oder den Klassifikator 80 implementiert.

Alternativ oder zusätzlich kann eine oder die digitale Signalvorverarbeitungseinheit 50 hardwarebasiert ausgeführt sein, und/oder das System 100 und/oder die Verarbeitungseinheit 110 Hardware umfassen, die eine oder die digitale Signalvorverarbeitungseinheit 50 verwirklicht. In einigen Ausführungsformen kann eine oder die weitere digitale Signalvorverarbeitungseinheit 60 hardwarebasiert ausgeführt sein, und/oder das System 100 und/oder die Verarbeitungseinheit 110 Hardware umfassen, die eine oder die weitere digitale Signalvorverarbeitungseinheit 60 verwirklicht. In einigen Ausführungsformen kann eine oder die Merkmalsextraktionseinheit 70 hardwarebasiert ausgeführt sein, und/oder das System 100 und/oder die Verarbeitungseinheit 110 Hardware umfassen, die eine oder die Merkmalsextraktionseinheit 70 verwirklicht. In einigen Ausführungsformen kann einer oder der Klassifikator 80 hardwarebasiert ausgeführt sein, und/oder das System 100 und/oder die Verarbeitungseinheit 110 Hardware umfassen, die einen oder den Klassifikator 80 verwirklicht.

Entsprechende Hardware kann beispielsweise ein Computergerät, ein Prozessor, ein Mikroprozessor (MPU), ein digitaler Signalprozessor (DSP), ein Microcontroller, ein integrierter Schaltkreis (IC), ein eingebettetes System, ein Logikbaustein, ein Field Programmable Gate Array (FPGA), ein Complex Programmable Logic Device (CPLD) oder dergleichen sein oder aufweisen.

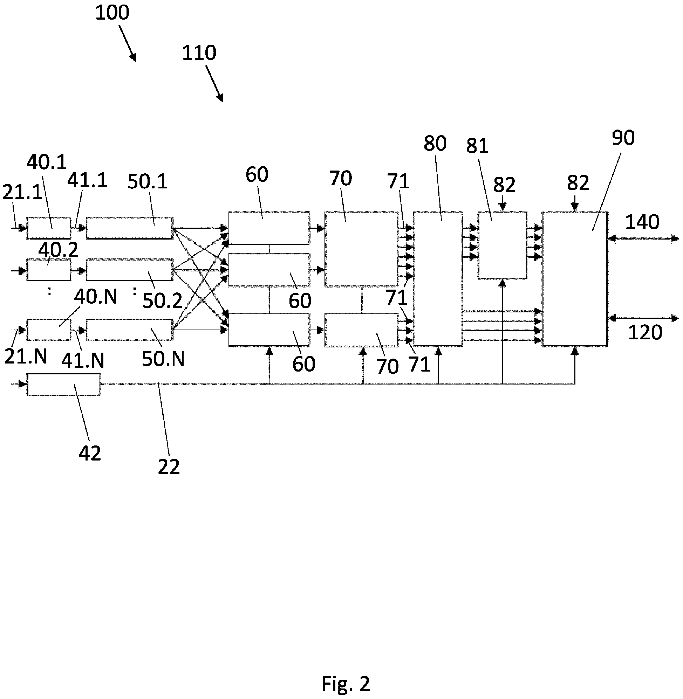

Fig. 2 zeigt eine beispielhafte Ausführungsform eines erfindungsgemäßen Systems 100. Das System 100 kann die in Figur 1 gezeigten und beschriebenen Komponenten, aufweisen. Einige der Komponenten des Systems 100 können aber nicht in Figur 2 gezeigt sein.

Insbesondere können die einem oder dem A/D-Wandler 40 vorgelagerten Komponenten, beispielsweise ein oder der elektromechanische Energiewandler 10, Sensoren 20, und/oder analoge Signalvorverarbeitung 30 nicht in Figur 2 gezeigt sein.

Eine Anzahl N Messwerte 21.1, 21.2, ..., 21. N können von einer entsprechenden Anzahl Sensoren 20 erfasst sein oder werden. Die Messwerte 21.1, 21.2, ..., 21.N können in einigen Ausführungsformen von einer oder der analogen Signalvorverarbeitung 30 vorverarbeitet sein oder worden sein. Allgemein kann von N Eingangskanälen und/oder Signalkanälen ausgegangen werden.

Jeder Messwert 21.1, 21.2, ..., 21.N kann von einem entsprechenden A/D-Wandler 40.1, 40.2, ..., 40.N in ein entsprechendes digitales Signal 41.1,41.2, ..., 41.N umgewandelt sein oder werden. Die digitale Umwandlung kann parallel erfolgen. Alternativ oder zusätzlich kann vorgesehen sein, dass ein A/D-Wandler 40 mehrere oder alle Messwerte 21.1, 21.2, ..., 21. N in entsprechende digitale Signale 41.1,41.2, ..., 41.N umwandeln kann, beispielsweise in oder mit einem Multiplex-Verfahren.

Es kann eine digitale Signalvorverarbeitung vorgesehen sein. Beispielsweise kann eine oder mehrere digitale Signalvorverarbeitungseinheiten 50, z.B. digitale Signalvorverarbeitungseinheiten 50.1, 50.2, 50.N, vorgesehen sein. Eine oder mehrere digitale Signalvorverarbeitungseinheiten 50 kann dazu eingerichtet sein, eine digitale Signalvorverarbeitung durchzuführen. Das oder die digitalen Signale 41.1,41.2, ..., 41.N können einer oder mehreren digitalen Signalvorverarbeitungseinheiten 50 zugeführt sein oder werden.

In einigen Ausführungsformen kann vorgesehen sein, dass durch die digitale Signalvorverarbeitung ein digitales Signal 41 entrauscht sein oder werden kann, und/oder ein Signal-Rausch-Verhältnis eines digitalen Signals 41 verbessert sein oder werden kann. Eine digitale Signalvorverarbeitung kann beispielsweise dann sinnvoll und/oder vorgesehen sein, wenn die Messdaten 21 und/oder digitale Signale 41 von Störsignalen durchsetzt sind, die für die Zustandsanalyse jedoch keine Bedeutung haben. Diese Störsignale können Rauschen entsprechend und/oder als Rauschen bezeichnet sein oder werden.

In der rauen Umgebung eines elektromechanischen Energiewandlers 10, z.B. eines Motors, treten i.A. stark verrauschte Eingangssignalen auf. Um das Signal-Rausch-Verhältnis der Messdaten 21 und/oder digitalen Signalen 21 zu verbessern, kann bei der digitalen Signalvorverarbeitung beispielsweise eines oder mehrere aus Tiefpassfilter, Notch-Filter, Fourier-Transformation z.B. FFT und/oder DFT) und/oder Wavelets zur Rauschreduzierung vorgesehen sein.

Es kann vorgesehen sein, dass bei der digitalen Signalvorverarbeitung die Messdaten jedes einzelnen Sensors, und/oder die digitale Signale 41.1, 41.2, ..., 41. N separat bearbeitet sind oder werden. Beispielsweise kann ein digitales Signal 41.1, 41.2, ..., 41.N von einer entsprechenden digitalen Signalvorverarbeitungseinheit 50.1, 50.2, ..., 50.N bearbeitet und/oder entrauscht sein oder werden.

In einigen Ausführungsformen kann alternativ oder zusätzlich eine kanalübergreifende digitale Signalvorverarbeitung vorgesehen sein. Es kann eine oder mehrere weitere digitale Signalvorverarbeitungseinheiten 60 vorgesehen sein. Die eine oder mehrere digitale Signalvorverarbeitungseinheiten 60 kann dazu eingerichtet sein, eine oder die kanalübergreifende digitale Signalvorverarbeitung durchzuführen.

Beispielsweise können mindestens zwei, mehrere oder alle digitalen Signale 41.1, 41.2, ..., 41.N, und/oder mindestens zwei, mehrere oder alle durch die digitale Signalvorverarbeitung bearbeitete Signale, durch die kanalübergreifende digitale Signalvorverarbeitung bearbeitet sein oder werden.

In einigen Ausführungsformen können bei der kanalübergreifenden digitale Signalvorverarbeitung Signale, z.B. mindestens zwei, mehrere oder alle digitalen Signale 41.1, 41.2, ..., 41.N, und/oder mindestens zwei, mehrere oder alle durch die digitale Signalvorverarbeitung bearbeitete Signale, miteinander in Beziehung gesetzt sein oder werden. In einigen Ausführungsformen können Korrelationen mindestens zweier Signale bestimmt und/oder ermittelt sein oder werden.

Bei der kanalübergreifenden digitale Signalvorverarbeitung kann eine weitere Rauschreduzierung erreicht und/oder durchgeführt sein oder werden. Die kanalübergreifenden digitale Signalvorverarbeitung kann eine weitere Verbesserung des Signal-Rausch-Abstands ermöglichen.

In einigen Ausführungsformen können mit Verfahren zur Kanalseparation darüber hinaus die durch unterschiedliche Signalquellen an einem elektromechanischen Energiewandler 10, z.B. einem Motor, verursachten Vibrations- und/oder Schallsignale, und/oder photonische Ereignisse getrennt und dabei unterschiedlichen Quellen zugeordnet sein oder werden. Die Trennung der Einzelsignale kann eine oder die Zustandsbestimmung des elektromechanischen Energiewandlers 10 vereinfachen.

In einigen Ausführungsformen kann eine kanalübergreifenden digitale Signalvorverarbeitung vorgesehen sein, aber keine digitale Signalvorverarbeitung vorgesehen sein. In einigen Ausführungsformen kann eine oder mehrere weitere digitale Signalvorverarbeitungseinheiten 60 vorgesehen sein, digitale Signalvorverarbeitung 50. Beispielsweise kann eines oder mehrere der mit dem oder den A/D-Wandler 40, 40.1, 40.2, ..., 40.N umgewandelten digitalen Signale 41, 41.1, 41.2, ..., 41.N ein Eingangssignal für eine oder die kanalübergreifende digitale Signalvorverarbeitung sein, und/oder ein Eingangssignal für eine oder mehrere kanalübergreifende digitale Signalvorverarbeitungseinheiten 60 sein.

In einigen Ausführungsformen kann eine digitale Signalvorverarbeitung vorgesehen sein, aber keine kanalübergreifende digitale Signalvorverarbeitung vorgesehen sein. In einigen Ausführungsformen kann eine oder mehrere digitale Signalvorverarbeitungseinheiten 50, 50.1, 50.2, ..., 50.N vorgesehen sein, aber keine weitere digitale Signalvorverarbeitung 60. Beispielsweise kann eines oder mehrere der mit dem oder den A/D-Wandler 40, 40.1, 40.2, ..., 40.N umgewandelten digitalen Signale 41, 41.1, 41.2, ..., 41.N ein Eingangssignal für eine oder die digitale Signalvorverarbeitung 50, 50.1, 50.2, ... 50.N sein.

In einigen Ausführungsformen kann eine digitale Signalvorverarbeitung vorgesehen sein, und zudem kann eine kanalübergreifende digitale Signalvorverarbeitung vorgesehen sein. In einigen Ausführungsformen kann eine oder mehrere digitale Signalvorverarbeitungseinheiten 50, 50.1, 50.2, ..., 50.N vorgesehen sein, und eine oder mehrere weitere digitale Signalvorverarbeitungen 60. Beispielsweise kann eines oder mehrere der mit dem oder den A/D-Wandler 40, 40.1, 40.2, ..., 40. N umgewandelten digitalen Signale 41, 41.1, 41.2, ..., 41.N ein Eingangssignal für eine oder die digitale Signalvorverarbeitung 50, 50.1, 50.2, ... 50.N sein. Beispielsweise kann eines oder mehrere der mit der oder den digitalen Signalvorverarbeitungseinheiten 50, 50.1, 50.2, ..., 50.N bearbeiteten digitalen Signale 41, 41.1, 41.2, ..., 41.N ein Eingangssignal für eine oder die weitere digitale Signalvorverarbeitung 60 sein.

In einigen Ausführungsformen kann weder eine digitale Signalvorverarbeitung vorgesehen sein, noch eine kanalübergreifende digitale Signalvorverarbeitung vorgesehen sein. In einigen Ausführungsformen kann das System weder eine digitale Signalvorverarbeitungseinheit 50 noch eine weitere digitale Signalvorverarbeitungseinheit 60 umfassen.

Mit einer Merkmalsextraktion kann eines oder mehrere Merkmale 71 aus dem oder den digitalen Signalen 41, 41.1, 41.2, ... 41. N extrahiert sein oder werden. Das System 100 kann eine oder mehrere Merkmalsextraktionseinheiten 70 aufweisen. Die Merkmalsextraktionseinheit 70 kann dazu eingerichtet sein, eines oder mehrere Merkmale aus einem oder mehreren Eingangssignalen der Merkmalsextraktionseinheit 70 zu extrahieren.

In einigen Ausführungsformen kann eines oder mehrere von einer oder der digitale Signalvorverarbeitungseinheit 50, 50.1, 50.2, ..., 50.N bearbeiteten Signals einer Merkmalsextraktionseinheit 70 zugeführt sein oder werden, und/oder ein entsprechendes Eingangssignal einer Merkmalsextraktionseinheit 70 sein. In einigen Ausführungsformen kann eines oder mehrere von einer oder der weiteren digitale Signalvorverarbeitungseinheit 60 bearbeiteten Signals einer Merkmalsextraktionseinheit 70 zugeführt sein oder werden, und/oder ein entsprechendes Eingangssignal einer Merkmalsextraktionseinheit 70 sein. In einigen Ausführungsformen kann eines oder mehrere von einem oder dem A/D-Wandler 40, 40.1, 40.2, ..., 40. N umgewandelten Signals einer Merkmalsextraktionseinheit 70 zugeführt sein oder werden, und/oder ein entsprechendes Eingangssignal einer Merkmalsextraktionseinheit 70 sein.

Bei der Merkmalsextraktion kann das oder die Merkmale aus einem zeitlichen Verlauf des oder der Eingangssignale der Merkmalsextraktionseinheit 70 extrahiert sein oder werden. Es kann vorgesehen sein, die Eingangssignale, insbesondere Zeitsignale und/oder zeitliche Verläufe der Eingangssignale, so zu transformieren, dass möglichst nur solche Daten verbleiben, die eine Einschätzung des Zustands des elektromechanischen Energiewandlers 10 zuverlässig ermöglichen.

Die Merkmalsextraktion kann die Daten unterschiedlicher Kanäle zusammenführen, oder sich auf einen einzelnen Kanal beziehen. Beispielsweise können mehrere Signale einer Merkmalsextraktionseinheit 70 zugeführt sein oder werden. Es kann vorgesehen sein, bei einer oder der Merkmalsextraktion verschiedene Eingangssignale, und/oder deren zeitliche Verläufe, für und/der bei der Extraktion der Merkmale zu berücksichtigen. Alternativ oder zusätzlich kann vorgesehen sein, dass ein einziges Signal einer Merkmalsextraktionseinheit 70 zugeführt sein oder werden kann. Es kann vorgesehen sein, bei einer oder der Merkmalsextraktion ein einziges Eingangssignal, und/oder dessen zeitlichen Verlauf, für und/der bei der Extraktion der Merkmale zu berücksichtigen.

In einigen Ausführungsformen können mehrere Merkmalsextraktionseinheiten 70 vorgesehen sein, und/oder Signale in verschiedener Kombination und/oder jeweils für sich als Grundlage der Merkmalsextraktion verwendet sein oder werden. Es kann vorgesehen sein, dass mindestens ein Signal als einziges Signal für eine Merkmalsextraktion vorgesehen sein kann, und/oder dass eines oder mehrere Merkmale nur aus mindestens einem einzelnen Signal extrahiert sein oder werden können. Alternativ oder zusätzlich kann vorgesehen sein, dass mindestens zwei Signale, in einigen Fällen zwei von dem mindestens einen einzelnen Signal verschiedene Signale, für eine Merkmalsextraktion vorgesehen sein können, und/oder dass eines oder mehrere Merkmale mindestens zwei Signalen, in einigen Fällen zwei von dem mindestens einen einzelnen Signal verschiedene Signale, gemeinsam extrahiert sein oder werden können.

Bei einer Extraktion eines oder mehrerer Merkmale kann in einigen Ausführungsformen eines oder mehrere aus Fouriertransformation (z.B. DFT und/oder FFT), Wavelettransformation und/oder Templatematching vorgesehen und/oder durchgeführt sein oder werden. Eine oder die Merkmalsextraktion kann eines oder mehrere aus Fouriertransformation (z.B. DFT und/oder FFT), Wavelettransformation und/oder Templatematching umfassen. Alternativ oder zusätzlich kann bei einer Merkmalsextraktion eines oder mehrere Merkmale direkt durch Auswertung der Eingangssignale, z.B. Zeitsignale und/oder zeitlichen Verläufen des oder der Eingangssignale, extrahiert sein oder werden. Beispielsweise kann die Hüllkurven der jeweiligen Signale ermittelt sein oder werden.

Das oder die extrahierten Merkmale können klassifiziert sein oder werden. Das System 100 kann einen Klassifikator 80 umfassen. Der Klassifikator 80 kann dazu eingerichtet sein, eine Merkmalsklassifizierung durchzuführen.

Bei der Klassifikation der Merkmale können vergleichbaren Merkmalen bestimmten Ursachen zugeordnet werden. Es kann vorgesehen sein, dass bei der Klassifikation der Merkmale die Merkmale gruppiert sein oder werden können.

Eine Klassifikation kann hilfreich sein, da verschiedene oder mehrfache Messungen, und/oder verschiedenes oder mehrfaches Erfassen von Messwerten 21, nicht zwingend identische Messwerte 21 und/oder digitale Signale 41 generieren muss.

Die Klassifizierung erlaubt zudem, dass eine Bestimmung von Zuständen und/oder Fehlerursachen für unterschiedliche elektromechanische Energiewandler 10 ermöglicht sein oder werden kann, die sich z.B. bezüglich der auftretenden Vibrations-, Schallemissionen und photonischen Ereignissen unterscheiden können.

Für und/oder bei der Klassifikation kann z.B. eines oder mehrere aus neuronalen Netzen, Fuzzy-Logiken, Support Vector Machine (SVM), maschinelles Lernen oder dergleichen vorgesehen und/oder verwendet sein oder werden.

Mit Hilfe des Klassifikators 80 können sich Aussagen über den Zustand eines elektromechanischen Energiewandlers 10 treffen lassen. Beispielsweise können dabei einzelne Vibrationsereignisse, Schallereignisse und/oder photonische Ereignisse klassifiziert sein oder werden.

Der Zustand eines elektromechanischen Energiewandlers 10, z.B. eines Motors, kann sich über die Zeit verändern, häufig in kleinen Schritten.

In einigen Ausführungsformen kann ein zweiter Klassifikator 81 vorgesehen sein. Der zweite Klassifikator 81 kann zeitliche Änderungen und/oder Verläufe des Zustands des elektromechanischen Energiewandlers 10 ermitteln, detektieren und/oder erfassen. Dadurch kann die Zuverlässigkeit der Zustandseinschätzung erhöht sein oder werden. Der zweite Klassifikator 81 kann in einigen Ausführungsformen eine weitere Klassifikation durchführen.

Es kann vorgesehen sein, dass eine Zeitinformation 82 eine Eingangsgröße des zweiten Klassifikators 81 sein kann, und/oder dass der zweite Klassifikator 81 Zeitinformationen 82 berücksichtigen kann.

Es kann vorgesehen sein, dass eine Zeitinformation 82 eine Eingangsgröße des Klassifikators 80 sein kann, und/oder dass der Klassifikator 80 Zeitinformationen 82 berücksichtigen kann.

Der zweite Klassifikator 81 kann in einigen Ausführungsformen die Zeitinformation 82 dem von dem ersten Klassifikator erstellten Klassifikation und/oder dem von dem ersten Klassifikator bestimmten Zustand und/oder Fehlerursache zuordnen. Der zweite Klassifikator 81 kann in einigen Ausführungsformen die von dem ersten Klassifikator erstellte Klassifikation und/oder den von dem ersten Klassifikator bestimmten Zustand und/oder Fehlerursache mit einem Zeitstempel versehen.

In einigen Ausführungsformen kann nur ein Klassifikator 80, aber kein zweiter Klassifikator 81 vorgesehen sein. In einigen Ausführungsformen kann der Klassifikator 80 und der zweite Klassifikator 81 kombiniert sein oder werden, beispielsweise zu einem einzigen Klassifikator. In einigen Ausführungsformen kann der Klassifikator 80 die zusätzliche Funktion des zweiten Klassifikators 81 ausführen und/oder erfüllen. In einigen Ausführungsformen kann der Klassifikator 80 eine oder die Zeitinformation 82 als Eingangsgröße haben. In einigen Ausführungsformen kann der Klassifikator 80 die Zeitinformation 82 der Klassifikation und/oder dem bestimmten Zustand und/oder Fehlerursache zuordnen. Der Klassifikator 80 kann in einigen Ausführungsformen die Klassifikation und/oder bestimmten Zustand und/oder Fehlerursache mit einem Zeitstempel versehen.

Eine Trennung der Funktionalität von Klassifikator 80 und zweitem Klassifikator 81 kann in einigen Ausführungsformen vorteilhaft sein, wenn z.B. der Klassifikator Merkmale instantan klassifizieren und der zweite Klassifikator 81 die von dem Klassifikator 80 erstellte Klassifikation über die Zeit sammeln und anschließend nochmals klassifizieren, und/oder einen Zustand und/oder eine Fehlerursache, bestimmen kann. In einigen Ausführungsformen kann die Klassifizierung, und/oder Bestimmung des Zustands und/oder der Fehlerursache, des Klassifikators 80 instantan und/oder für einen bestimmten Zeitpunkt gegeben sein, und die Klassifizierung, und/oder Bestimmung des Zustands und/oder der Fehlerursache, des zweiten Klassifikators 81 für ein Zeitintervall gegeben sein. Es kann aber auch in diesen Ausführungsformen nur ein Klassifikator vorgesehen sein, der die Funktionalität des Klassifikators 80 und des zweiten Klassifikators 81 kombinieren und/oder aufweisen kann.

Für und/oder bei der weiteren Klassifikation, und/oder bei der Ermittlung, Detektierung und/oder Erfassung zeitlicher Änderungen des Zustands, kann z.B. eines oder mehrere aus neuronalen Netzen, Fuzzy-Logiken, Support Vector Machine (SVM), maschinelles Lernen oder dergleichen vorgesehen und/oder verwendet sein oder werden.

In einigen Ausführungsformen kann eine Aufbereitungseinheit 90 vorgesehen sein. Die Aufbereitungseinheit 90 kann dazu eingerichtet sein, den bestimmten Zustand und/oder die bestimmte Fehlerursache, und/oder entsprechende zeitliche Verläufe, in eine für Menschen leicht verständliche Form zu übersetzen, und/oder umzuwandeln. Damit kann der bestimmte Zustand und/oder die bestimmte Fehlerursache, und/oder entsprechende zeitliche Verläufe, z.B. leicht von Wartungspersonal interpretiert oder verstanden sein oder werden.

Die Aufbereitungseinheit 90 kann eine Aufbereitung und/oder Auswertung des bestimmten Zustands und/oder der bestimmten Fehlerursache, und/oder entsprechender zeitlicher Verläufe, durchführen. Beispielsweise kann der bestimmte Zustand und/oder die bestimmte Fehlerursache, und/oder entsprechende zeitliche Verläufe, in tabellarischer Form, als Graph oder Diagramm, durch Auflistung von Wahrscheinlichkeiten oder dergleichen ausgewertet oder repräsentiert sein oder werden. Die Auswerteeinheit 90 kann z.B. aus dem bestimmten Zustand und/oder der bestimmten Fehlerursache, und/oder entsprechenden zeitlichen Verläufen, Tabelle, Graphen und/oder Diagramme erstellen, und/oder Wahrscheinlichkeiten zuordnen und/oder berechnen. Eine Aufbereitung und/oder Auswertung kann z.B. eine oder mehrere Tabellen, Graphen und/oder Diagramme, Wahrscheinlichkeiten oder dergleichen umfassen.

Es kann vorgesehen sein, dass die entsprechende Auswertung und/oder Aufbereitung mit oder auf einer oder der Ausgabeeinheit 130, z.B. einem Display, angezeigt und/oder ausgegeben sein oder werden kann.

In einigen Ausführungsformen kann für eine schnelle Zustandsanalyse alternativ oder zusätzlich eine binäre Darstellung oder eine Darstellung in Ampelform bzw. als Ampel vorgesehen sein. Beispielsweise kann "Grün" bedeuten, dass der elektromechanische Energiewandler 10 aktuell keiner Wartung bedarf. Z.B. kann "Gelb" bedeuten, dass der elektromechanische Energiewandler 10 weiter betrieben werden kann, aber zeitnah gewartet werden sollte, da es Veränderungen im Verhalten des elektromechanischen Energiewandlers 10 gegeben hat (oder zumindest solche bestimmt oder ermittelt wurden), die zu einem Abweichen gegenüber dem Ursprungszustand geführt haben. Z.B. kann "Rot" bedeuten, dass der elektromechanische Energiewandler 10 nicht mehr sicher betrieben werden kann. Die entsprechende "Ampelfarbe" bzw. Farbeinteilung kann durch die Aufbereitungseinheit 90 ermittelt oder bestimmt sein oder werden. Die "Ampelfarbe" kann beispielsweise durch die Ausgabeeinheit 130, z.B. ein Display oder eine LED, angezeigt sein oder werden. Es können aber auch mehr oder weniger "Ampelfarben" und/oder Zwischenstufen der jeweiligen Zustände vorgesehen sein.

Es kann vorgesehen sein, dass der bestimmte Zustand oder die bestimmten Zustände, und/oder die bestimmte Fehlerursache, und/oder entsprechende zeitliche Verläufe, über ein Netzwerk 120 weitergeleitet werden können. Beispielsweise kann der bestimmte Zustand und/oder die bestimmte Fehlerursache, und/oder entsprechende zeitliche Verläufe, an ein weiteres Gerät, z.B. ein externes Gerät, das mit dem System 100 zum Datenaustausch verbunden sein kann, übertragen sein oder werden. In einigen Ausführungsformen kann der bestimmte Zustand und/oder die bestimmte Fehlerursache, und/oder entsprechende zeitliche Verläufe, z.B. an einen Server übertragen werden, und/oder auf einem Server hinterlegt sein oder werden.

Die beschriebenen Einheiten und/oder Schritte müssen nicht zwingend alle in jeder Ausführungsform vorliegen. Es kann auch vorgesehen sein, dass mehrere Einheiten und/oder Schritte, insbesondere bei einer Softwareimplementierung dieser, zusammengefasst, und/oder gemeinsam oder parallel, bearbeitet oder durchgeführt sein oder werden können. Lediglich beispielhaft kann der Klassifikator 80 und der zweite Klassifikator 81 als ein einziger Klassifikator realisiert oder ausgeführt sein.

In einigen Ausführungsformen kann vorgesehen, die Reihenfolge bei der Ausführung mindestens einen oder mehrere Schritte und/oder Einheiten zu modifizieren, und/oder auf einzelne Schritte zu verzichten. In einigen Ausführungsformen kann eine Reihenfolge mindestens zweier Schritte und/oder Einheiten vertauscht sein oder werden.

Figur 3 zeigt einen beispielhaften elektromechanischen Energiewandler 10. Der elektromechanischen Energiewandler 10 kann einen Stator 200 und einen Läufer 210 aufweisen. Der Läufer 210 kann ein Rotor sein oder aufweisen. Der Läufer 210 kann relativ zu dem Stator 200 drehbar sein.

Der Stator 200 kann eine oder mehrere Statorwicklungen 230 aufweisen. Die Statorwicklung 230 kann einen Wickelkopf 250 und/oder eine Spule umfassen. Der Stator 200 kann eine oder mehrere Aufnahmen aufweisen, in denen jeweils eine Statorwicklung 230 und/oder ein Wickelkopf 250 aufgenommen sein kann. Die Aufnahme kann sich in Längsrichtung des Stators 200 erstrecken. Die Aufnahme kann sich parallel zu einer Drehachse des Läufers 210 erstrecken. Die Statorwicklung 230, der Wickelkopf 250 und/oder die Spule der Statorwicklung 230 kann eine Isolierung aufweisen.

Der Läufer 210 kann eine oder mehrere Läuferwicklungen 240 aufweisen. Die Läuferwicklung 240 kann einen Wickelkopf und/oder eine Spule umfassen. Der Läufer 210 kann eine oder mehrere Aufnahmen aufweisen, in denen jeweils eine Läuferwicklung 240 und/oder ein Wickelkopf aufgenommen sein kann. Die Aufnahme kann sich in Längsrichtung des Läufers 100 erstrecken. Die Aufnahme kann sich parallel zu einer Drehachse des Läufers 210 erstrecken. Die Läuferwicklung 240, der Wickelkopf und/oder die Spule der Läuferwicklung 240 kann eine Isolierung aufweisen.

Der elektromechanische Energiewandler 10 kann ein Motor sein, insbesondere ein Elektromotor. Der elektromechanische Energiewandler 10 und/oder der Motor kann dazu eingerichtet sein, elektrische Energie in mechanische Energie zu wandeln, und/oder elektrische Leistung in mechanische Leistung zu wandeln. Beispielsweise kann unter Zufuhr eines elektrischen Stroms eine Translations- oder Drehbewegung des Läufers 210 erzeugt sein oder werden, die ein mechanische/s Kraft-/Drehmoment umfasst. Die Translations-/Drehbewegung und/oder die Kraft/ das mechanische Drehmoment kann an einer Welle des elektromechanischen Energiewandlers 10 abgegriffen werden.

Der elektromechanische Energiewandler 10 kann ein Generator sein, insbesondere ein elektrischer Generator. Der elektromechanische Energiewandler 10 und/oder der Generator kann dazu eingerichtet sein, mechanische Energie in elektrische Energie zu wandeln, und/oder mechanische Leistung in elektrische Leistung zu wandeln. Beispielsweise kann der Läufer 210 mit einer/m Translation/Drehmoment beaufschlagt sein, und ein elektrischer Strom infolge der Translation/Drehbewegung von dem Läufer 210 induziert sein oder werden. Die Translation/Drehbewegung kann an einer Welle des elektromechanischen Energiewandlers 10 angreifen.

Einer oder mehrere Sensoren 20 können an oder in dem elektromechanischen Energiewandler 10 angeordnet sein. Mindestens einer, mehrere oder alle der Sensoren 20 können ein faseroptischer Sensor und/oder ein faserakustischer Sensor sein oder aufweisen. Der Sensor 20 kann eine Faser 220 sein oder aufweisen. Die Sensor 20 und/oder die Faser 220 kann einen Messwert 20 erfassen. Aufgrund der geringen Abmaße der einzelnen Faser 220, die sich bereits als Sensor 20 eignen kann, kann eine oder mehrere Faserns 220 und/oder Sensoren 20 beispielsweise direkt in eines oder mehrere aus Statorwicklung 230, Läuferwicklung 240, Wickelkopf 250 und/oder Spule integriert sein oder werden.

Der Sensor 20 kann Vibrationen, Schall und/oder Lichtimpulse (Photonen) aufnehmen und/oder erfassen.

In einigen Ausführungsformen kann der Stator 200 eine Nut 260 haben. Mindestens ein Sensor 20, insbesondere mindestens eine Faser 220, kann in die Nut 260 aufgenommen sein. In einigen Ausführungsformen kann mindestens eine Nut 260 des Stators 200 in Längsrichtung des Stators 200 und/oder parallel zu der Drehachse des Läufers 210 verlaufen. In einigen Ausführungsformen kann alternativ oder zusätzlich mindestens eine Nut 260 des Stators 200 in Umfangsrichtung des Stators 200 verlaufen.

In einigen Ausführungsformen kann der Läufer 210 eine Nut 270 haben. Mindestens ein Sensor 20, insbesondere mindestens eine Faser 220, kann in die Nut 270 aufgenommen sein. In einigen Ausführungsformen kann mindestens eine Nut 270 des Läufers 210 in Längsrichtung des Läufers 210 und/oder parallel zu der Drehachse des Läufers 210 verlaufen. In einigen Ausführungsformen kann alternativ oder zusätzlich mindestens eine Nut 270 des Läufers 210 in Umfangsrichtung des Läufers 210 verlaufen.

Alternativ oder zusätzlich kann vorgesehen sein, dass ein Sensor 200 und/oder eine Faser 220 in eine Aufnahme des Stators 200, die für die Aufnahme einer Statorwicklung 230, eines Wickelkopfs 250 und/oder einer Spule eingerichtet ist, aufgenommen sein kann. In einigen Aufnahmen kann ein Sensor 200 und/oder eine Faser 220 in eine Aufnahme des Stators 200, in die eine Statorwicklung 230, ein Wickelkopf 250 und/oder einer Spule aufgenommen ist, aufgenommen sein. Der Sensor 200 und/oder die Faser 220 kann freiliegend sein

Alternativ oder zusätzlich kann vorgesehen sein, dass ein Sensor 200 und/oder eine Faser 220 in eine Aufnahme des Läufers 210, die für die Aufnahme einer Läuferwicklung 240, eines Wickelkopfs 250 und/oder einer Spule eingerichtet ist, aufgenommen sein kann. In einigen Aufnahmen kann ein Sensor 200 und/oder eine Faser 220 in eine Aufnahme des Läufers 210, in die eine Statorwicklung 230, ein Wickelkopfs 250 und/oder einer Spule aufgenommen ist, aufgenommen sein. Der Sensor 200 und/oder die Faser 220 kann freiliegend sein.

In einigen Ausführungsformen kann ein Sensor 20 und/oder eine Faser 220 in die Statorwicklung 230 integriert sein. In einigen Ausführungsformen kann der Sensor 20 und/oder die Faser 220 in eine Spule und/oder Wickelkopf 250 der Statorwicklung 230 eingewickelt und/oder mit dieser verwunden sein. In einigen Ausführungsformen kann der Sensor 230 und/oder die Faser 200 dabei nicht eine Isolierung, und/oder die Wicklung und/oder Spule, durchdringen und/oder in diese eingesetzt sein Alternativ oder zusätzlich kann ein Sensor 20 und/oder eine Faser 220 in eine Isolierung der Statorwicklung 230, eines Wickelkopfs und/oder einer Spule integriert, angeordnet und/oder aufgenommen sein.

In einigen Ausführungsformen kann ein Sensor 20 und/oder eine Faser 220 in die Läuferwicklung 240 integriert sein. In einigen Ausführungsformen kann der Sensor 20 und/oder die Faser 220 in eine Spule und/oder Wickelkopf 250 der Läuferwicklung 240 eingewickelt und/oder mit dieser verwunden sein. In einigen Ausführungsformen kann der Sensor 230 und/oder die Faser 200 dabei nicht eine Isolierung, und/oder die Wicklung und/oder Spule, durchdringen und/oder in diese eingesetzt sein. Alternativ oder zusätzlich kann ein Sensor 20 und/oder eine Faser 220 in eine Isolierung der Läuferwicklung 240, eines Wickelkopfs und/oder einer Spule integriert, angeordnet und/oder aufgenommen sein.

Alternativ oder zusätzlich kann in einigen Ausführungsformen mindestens ein Sensor 20 an einer Außenseite des elektromechanischen Energiewandlers 10, z.B. des Stators 200 und/oder des Läufers 210, angeordnet sein.

Die Erfindung ist nicht auf einen bestimmten elektromechanischen Energiewandler oder auf eine Variante oder Typ eines elektromechanischen Energiewandlers beschränkt. Die Erfindung ist nicht hinsichtlich der Spannungsebene oder der Leistungsklasse des elektromechanischen Energiewandlers 10 beschränkt.

Die in den Ansprüchen, der Beschreibung und/oder den Figuren offenbarten Merkmale können einzeln oder in beliebiger Kombination für die Verwirklichung der Erfindung wesentlich sein.

### Bezugszeichenliste

- 10: elektrischer Energiewandler
- 20: Sensor
- 21: Messwert
- 22: Steuersignal
- 30: analoge Signalvorverarbeitungsvorrichtung
- 40: A/D-Wandler
- 41: digitales Signal
- 42: Port
- 50: digitale Signalvorverarbeitungseinheit
- 60: weitere digitale Signalvorverarbeitungseinheit
- 70: Merkmalsextraktionseinheit
- 71: Merkmal
- 80: Klassifikator
- 81: zweiter Klassifikator
- 82: Zeitinformation
- 90: Aufbereitungseinheit

- 100: System
- 110: Verarbeitungseinheit
- 120: Netzwerk
- 130: Peripheriegerät
- 140: Eingabeschnittstelle
- 150: Ein-/Ausgabe

- 200: Stator
- 210: Läufer
- 220: Faser
- 230: Statorwicklung
- 240: Läuferwicklung
- 250: Wicklungskopf
- 260: Nut
- 270: Nut

## Patentansprüche

1. Verfahren zur Zustandsanalyse eines elektromechanischen Energiewandlers (10), bevorzugt eines Motors oder eines Generators, umfassend die Schritte:
- Erfassen mindestens eines Messwerts (21) des elektromechanischen Energiewandlers (10) mit mindestens einem Sensor (20), wobei mindestens einer, mehrere oder alle der Sensoren (20) in oder an dem elektromechanischen Energiewandler (10) angeordnet ist und wobei mindestens einer, mehrere oder alle der Sensoren (20) ein faseroptischer und/oder faserakustischer Sensor ist oder aufweist, wobei beim Erfassen des Messwerts (21) eines oder mehrere aus Vibration, Schall, Lichtimpulsen, Temperatur, Drehzahl, translatorische oder rotatorische Bewegung, elektrischer Spannung und/oder Stromstärke erfasst wird;
- Umwandeln des oder der Messwerte (21) mit mindestens einem A/D-Wandler (40) in ein jeweiliges digitales Signal (41);
- Durchführung einer Merkmalsextraktion des oder der digitalen Signale (41), wobei mindestens ein Merkmal (71) aus mindestens einem, mehreren oder allen digitalen Signalen (41) extrahiert wird, wobei bevorzugt eine Hüllkurve eines, mehrerer oder aller der digitalen Signale (41) bestimmt wird und/oder bevorzugt eine Fouriertransformation, eine Wavelettransformation und/oder ein Templatematching durchgeführt wird;
- Durchführen einer Klassifikation des oder der extrahierten Merkmale (71) mit einem Klassifikator (80) und Bestimmen eines Zustands und/oder einer Fehlerursache des elektromechanischen Energiewandlers (10) entsprechend der Klassifikation, wobei bevorzugt eine in dem elektromechanischen Energiewandler (10) auftretende Teilentladung erkannt und/oder bestimmt wird, wobei bevorzugt beim Klassifizieren das oder die extrahierten Merkmale (71) gruppiert werden.

2. Verfahren nach Anspruch 1, wobei von mindestens einem der Sensoren (20) ein Messwert (20) an oder in einer Läuferwicklung (240) und/oder einer Nut (270) eines Läufers (210) des elektromechanischen Energiewandlers (10) erfasst wird, und/oder wobei von mindestens einem der Sensoren (20) ein Messwert (20) an oder in einer Statorwicklung (230) und/oder einer Nut (260) eines Stators (200) des elektromechanischen Energiewandlers (10) erfasst wird.

3. Verfahren nach einem der vorhergehenden Ansprüche, wobei Messwerte (20) von mindestens zwei Sensoren (20) erfasst werden, wobei mindestens zwei der Sensoren unterschiedliche Bandbreiten haben, so dass Messwerte (21) innerhalb einer kombinierten Bandbreite der mindestens zwei Sensoren (20) erfassbar sind, wobei bevorzugt die Bandbreite eines Sensors (20) Infraschall und die Bandbreite eines anderen Sensors (20) Ultraschall umfasst.

4. Verfahren nach einem der vorhergehenden Ansprüche, wobei nach dem Erfassen eines oder der Messwerte (21) eine analoge Signalvorverarbeitung durchgeführt wird, wobei bevorzugt der oder die Messwerte (21) mit einem Anti-Aliasing-Filter und/oder einem Verstärker vorverarbeitet werden.

5. Verfahren nach einem der vorhergehenden Ansprüche, wobei nach dem Umwandeln in ein digitales Signal (41) eine digitale Signalvorverarbeitung des digitalen Signals (41) durchgeführt wird, wobei die digitale Signalvorverarbeitung ein Durchführen einer Rauschreduzierung umfasst, wobei besonders bevorzugt die digitale Signalvorverarbeitung für jedes digitale Signal (41) separat durchgeführt wird.

6. Verfahren nach einem der vorhergehenden Ansprüche, wobei eine kanalübergreifende digitale Signalvorverarbeitung durchgeführt wird, wobei die kanalübergreifende digitale Signalvorverarbeitung ein Durchführen einer Rauschreduzierung umfasst, bevorzugt nach der digitalen Signalvorverarbeitung, wobei bei der kanalübergreifenden digitalen Signalvorverarbeitung mindestens zwei digitale Signale (41) berücksichtigt werden.

7. Verfahren nach einem der vorhergehenden Ansprüche, wobei bei der Merkmalsextraktion und/oder der Klassifizierung ein oder mehrere Steuersignal/e (22) des elektromechanischen Energiewandlers (10) berücksichtigt wird/werden.

8. Verfahren nach einem der vorhergehenden Ansprüche, wobei bei der Merkmalsextraktionen mindestens zwei oder mehr als zwei digitale Signale (41) zusammengeführt werden, wobei aus den mindestens zwei zusammengeführten digitalen Signalen (41) mindestens ein Merkmal (71) extrahiert wird.

9. Verfahren nach einem der vorhergehenden Ansprüche, wobei
- der Klassifikator (80) zudem eine Zeitinformation (82) als Eingangsgröße umfasst, und/oder
- nach dem Durchführen der Klassifikation ein zweiter Klassifikator (81) eine weitere Klassifikation basierend auf dem oder den extrahierten Merkmalen (71) und/oder der von dem Klassifikator erstellten Klassifikation durchführt, wobei der zweite Klassifikator (81) zudem eine Zeitinformation als Eingangsgröße umfasst, und/oder
- der zweite Klassifikator (81) zeitliche Änderungen des Zustands ermittelt.

10. Verfahren nach einem der vorhergehenden Ansprüche, wobei der bestimmte Zustand und/oder die Fehlerursache an ein weiteres Gerät (130), bevorzugt ein Human-Machine-Interface, ein Display, ein Computergerät und/oder ein Netzwerkgerät, übermittelt wird.

11. System zur Zustandsanalyse eines elektromechanischen Energiewandlers (10), aufweisend
- einen elektromechanischen Energiewandler (10), bevorzugt einen Motor oder einen Generator;
- mindestens einen Sensor (20), wobei der mindestens eine Sensor (20) ein faseroptischer und/oder faserakustischer Sensor ist oder aufweist, und wobei der mindestens eine Sensor (20) dazu eingerichtet ist, einen jeweiligen Messwert (21) des elektromechanischen Energiewandlers (10) zu erfassen, wobei der mindestens eine Sensor (20) dazu eingerichtet ist, beim Erfassen des jeweiligen Messwerts (21) eines oder mehrere aus Vibration, Schall, Lichtimpulsen, Temperatur, Drehzahl, translatorische oder rotatorische Bewegung, elektrischer Spannung und/oder Stromstärke zu erfassen;
- mindestens einen A/D-Wandler (40), der dazu eingerichtet ist, einen oder mehrere Messwerte (21) in ein jeweiliges digitales Signal (41) umzuwandeln;
- eine Merkmalsextraktionseinheit (70), die dazu eingerichtet ist, mindestens ein Merkmal (71) aus dem oder den digitalen Signalen (41) zu extrahieren, wobei bevorzugt die Merkmalsextraktionseinheit dazu eingerichtet ist, eine Hüllkurve des digitalen Signals (41) zu bestimmen, und/oder eine Fouriertransformation, eine Wavelettransformation und/oder ein Templatematching durchzuführen;
- einen Klassifikator (80), der dazu eingerichtet ist, eine Klassifikation der extrahierten Merkmale (71) durchzuführen und entsprechend der Klassifikation einen Zustand und/oder eine Fehlerursache des elektromechanischen Energiewandlers (10) zu bestimmen, bevorzugt eine in dem elektromechanischen Energiewandler (10) auftretende Teilentladung zu erkennen und/oder zu bestimmen.

12. System nach Anspruch 11, wobei der elektromechanischen Energiewandler (10) einen Stator (200) und einen Läufer (210) aufweist, wobei mindestens einer der Sensoren (20) in einer Nut (260) des Stators (200) und/oder einer Nut (270) des Läufers (210) angeordnet ist, und/oder wobei mindestens einer der Sensoren (20) in einer Läuferwicklung (240) des Läufers (210) und/oder einer Statorwicklung (230) des Stators (200) integriert ist.

13. System nach einem der Ansprüche 11 oder 12, aufweisend mindestens zwei Sensoren (20), wobei mindestens zwei der Sensoren (20) unterschiedliche Bandbreiten haben, so dass Messwerte (21) innerhalb einer kombinierten Bandbreite der Sensoren erfassbar sind, wobei bevorzugt die Bandbreite eines Sensors (20) Infraschall und die Bandbreite eines anderen Sensors (20) Ultraschall umfasst.

14. System nach einem der Ansprüche 11 bis 13, aufweisend
- eine analoge Signalvorverarbeitungsvorrichtung (30), die bevorzugt eines oder mehrere aus Verstärker, Anti-Aliasing-Filter und/oder Interferometer aufweist, wobei die analoge Signalvorverarbeitungsvorrichtung (30) mit mindestens einem der Sensoren (20) und/oder mindestens einem der A/D-Wandler (40) verbunden ist; und/oder
- eine digitale Signalvorverarbeitungseinheit (60, 70), die mit mindestens einem der A/D-Wandler (40) und/oder der Merkmalsextraktionseinheit (80) verbunden ist.

15. System nach einem der Ansprüche 11 bis 14, aufweisend einen zweiten Klassifikator (81), der dazu eingerichtet ist, zeitliche Änderungen des Zustands zu ermitteln und/oder wobei der zweite Klassifikator (81) dazu eingerichtet ist, nach oder bei dem Durchführen der Klassifikation eine weitere Klassifikation basierend auf dem oder den extrahierten Merkmalen (71) und/oder der von dem Klassifikator (80) erstellten Klassifikation durchzuführen, wobei der zweite Klassifikator zudem eine Zeitinformation (82) als Eingangsgröße umfasst.

16. System nach einem der Ansprüche 11 bis 15, weiter aufweisend ein weiteres Gerät (130), bevorzugt ein Human-Machine-Interface, ein Display und/oder ein Computergerät, wobei das weitere Gerät (130) dazu eingerichtet ist, den bestimmten Zustand und/oder die Fehlerursache auszugeben.
